# EUROPEAN PATENT APPLICATION

(11) **EP 4 756 564 A1**
(43) Date of publication of application: **10.06.2026**
(21) Application number: 24878530.5
(22) Date of filing: 20.06.2024
(51) Int. Cl.: G06F 1/16, F16C 11/04

(54) **HINGE APPARATUS, FOLDING APPARATUS, AND FOLDABLE ELECTRONIC DEVICE**

(30) Priority: 19.10.2023 CN 202311374997
(71) Applicant: HUAWEI TECHNOLOGIES CO., LTD., Shenzhen 518129 (CN)
(72) Inventor: NAGAI, Kenji, Shenzhen, Guangdong 518129 (CN); LIN, Hui, Shenzhen, Guangdong 518129 (CN); ZHAO, Xing, Shenzhen, Guangdong 518129 (CN)
(74) Representative: Pfenning, Meinig & Partner mbB
(86) International application number: PCT/CN2024/100380
(87) International publication number: WO 2025/081877

(57) **Abstract**

This application provides a hinge apparatus, a foldable apparatus, and a foldable electronic device. The hinge apparatus includes a base, a first hinge assembly, and a second hinge assembly. A compensation mechanism of each hinge assembly includes a first connecting rod, a second connecting rod, and a third connecting rod. Concentric portions of all the connecting rods are rotatably connected to each other. The concentric portions of all the connecting rods rotate around a third axis relative to the base. A rotating portion of the second connecting rod rotates around a first axis relative to the base under driving of a main swing arm and drives the concentric portions of all the connecting rods to rotate around the third axis relative to the base. A movable plate and the third connecting rod rotate relative to each other around a fourth axis. When the main swing arm rotates relative to the base, the movable plate slides relative to the main swing arm, to generate displacement in a direction toward or away from the base. Through the hinge apparatus provided in embodiments of this application, a length of the foldable apparatus in the foldable electronic device can be adjusted, to avoid squeezing or stretching of a display screen in a process of folding and unfolding.

## Description

This application claims priority to Chinese Patent Application No. 202311374997.2, filed with the China National Intellectual Property Administration on October 19, 2023 and entitled "HINGE APPARATUS, FOLDABLE APPARATUS, AND FOLDABLE ELECTRONIC DEVICE", which is incorporated herein by reference in its entirety.

### TECHNICAL FIELD

This application relates to the field of electronic devices, and in particular, to a hinge apparatus, a foldable apparatus, and a foldable electronic device.

### BACKGROUND

With the development of flexible display screens, foldability becomes an important direction for electronic device development. A foldable electronic device includes two parts that can rotate relative to each other. The two parts are rotatably connected through a hinge apparatus, to implement folding and unfolding of the foldable electronic device, to meet requirements of different use scenarios. The entire foldable electronic device includes a foldable apparatus (also referred to as a housing assembly, where the hinge apparatus is disposed in the foldable apparatus) and a display screen. The display screen is laid on a side of the foldable apparatus. When the foldable electronic device is folded and unfolded, the display screen is folded and unfolded together with the foldable apparatus. However, because the foldable apparatus and the display screen are stacked, and each have a specific thickness, a path difference exists between the display screen and the foldable apparatus in a process of folding and unfolding.

The foldable electronic device is classified as an inward folding electronic device and an outward folding electronic device. The inward folding electronic device is a foldable electronic device whose foldable apparatus surrounds a display screen in a folded state, and the outward folding electronic device is a foldable electronic device whose display screen surrounds a foldable apparatus in a folded state. The inward folding electronic device is used as an example. When the display screen and the foldable apparatus are not fastened, assuming that when the inward folding electronic device is in an unfolded state, the display screen and the foldable apparatus are aligned, and lengths of the display screen and the foldable apparatus are consistent. In this case, if the inward folding electronic device is switched to a folded state, the display screen and the foldable apparatus are misaligned, and two ends of the display screen protrude from the foldable apparatus. To ensure that the two ends of the display screen and two ends of the foldable apparatus in the inward folding electronic device are aligned in the folded state, a length of the foldable apparatus located on an outer side is longer than that of the display screen on an inner side. This means that the length of the foldable apparatus needs to be adjusted in a process of unfolding and folding the foldable electronic device to adapt to different forms of the display screen. In an actual product, two ends of a display screen are usually fastened on a foldable apparatus. If a length of the foldable apparatus cannot be adjusted in a process of folding and unfolding, the display screen is squeezed or stretched, damaging the display screen.

A length of a foldable apparatus in an existing foldable electronic device cannot be adjusted. For example, in a conventional technology, a hinge cover and a first rotating arm and a second rotating arm that are rotatably connected to two sides of the hinge cover are disposed in a hinge apparatus. The first rotating arm is fastened to a first housing, the second rotating arm is fastened to a second housing, and the first rotating arm and the second rotating arm rotate relative to each other through a pair of gear groups meshed with each other, so that the first housing and the second housing rotate relative to each other. Two ends of a display screen are respectively fastened to the first housing and the second housing, so that the display screen is unfolded and folded together with the first housing and the second housing. In this structure, a length of a foldable apparatus cannot be adjusted. Because the display screen is separately fastened to the first housing and the second housing, when the foldable electronic device is in a folded state, the display screen is squeezed and faces a risk of damage.

It can be learned that, in the conventional technology, the length of the foldable apparatus in the foldable electronic device cannot be adjusted. As a result, the display screen is squeezed or stretched in a process of folding and unfolding and faces a risk of damage.

### SUMMARY

Embodiments of this application provide a hinge apparatus, a foldable apparatus, and a foldable electronic device, to resolve a problem in the conventional technology that a length of a foldable apparatus in a foldable electronic device cannot be adjusted, and consequently, a display screen is squeezed or stretched in a process of folding and unfolding and faces a risk of damage.

An embodiment of this application provides a hinge apparatus for a foldable electronic device, including a base, a first hinge assembly, and a second hinge assembly. The first hinge assembly and the second hinge assembly are respectively disposed on two sides of the base in a first direction and are rotatably connected to the base. Each of the first hinge assembly and the second hinge assembly includes a main swing arm, a movable plate, and a compensation mechanism.

A main shaft is disposed on the base, and the main swing arm is rotatably connected to the base through the main shaft, so that the main swing arm rotates around a first axis relative to the base, where the first axis extends in a second direction, the second direction is an extension direction of the main shaft, and the second direction is perpendicular to the first direction. The movable plate is rotatably connected to the base through the main swing arm, a rotation axis is the first axis, and the movable plate is slidably connected to the main swing arm.

The compensation mechanism includes a first connecting rod, a second connecting rod, and a third connecting rod. Each of the first connecting rod, the second connecting rod, and the third connecting rod includes a concentric portion and a rotating portion that are spaced apart, concentric portions of all the connecting rods are rotatably connected to each other, and a rotation axis between any two connecting rods is a second axis.

The first connecting rod is rotatably connected to the base through the rotating portion of the first connecting rod, so that the concentric portions of all the connecting rods rotate around a third axis relative to the base. The second connecting rod is rotatably connected to the base through the rotating portion of the second connecting rod, and the rotating portion of the second connecting rod is mounted on the main shaft or the main swing arm, so that the rotating portion of the second connecting rod rotates around the first axis relative to the base under driving of the main swing arm and drives the concentric portions of all the connecting rods to rotate around the third axis relative to the base. The third connecting rod is rotatably connected to the movable plate through the rotating portion of the third connecting rod, and a rotation axis between the movable plate and the third connecting rod is a fourth axis, where all the second axis, the third axis, and the fourth axis extend in the second direction.

When the main swing arm rotates relative to the base, the movable plate slides relative to the main swing arm under driving of the main swing arm and the compensation mechanism, to generate displacement in a direction toward or away from the base. The movable plate of the first hinge assembly is fastened to a first housing of the foldable electronic device, and the movable plate of the second hinge assembly is fastened to a second housing of the foldable electronic device.

The hinge apparatus provided in this embodiment of this application is configured to implement unfolding and folding of the foldable electronic device. The first housing of the foldable electronic device is mounted on the movable plate of the first hinge assembly, and the second housing is mounted on the movable plate of the second hinge assembly. In a process of folding the foldable electronic device, the main swing arms of the first hinge assembly and the second hinge assembly separately rotate relative to the base. In this way, the main swing arms of the hinge assemblies rotate relative to each other, to drive the movable plates of the hinge assemblies to rotate relative to each other, so that the first housing and the second housing of the foldable electronic device rotate relative to each other.

The movable plate is slidably connected to the main swing arm, and a compensation mechanism is disposed in each hinge assembly. The compensation mechanism includes a first connecting rod, a second connecting rod, and a third connecting rod. Concentric portions of the three connecting rods are concentrically connected, and the second axis is a concentric axis. When the foldable electronic device is folded and unfolded, a movement track of the second axis is jointly controlled through rotation of the first connecting rod relative to the base, and eccentric movement of the rotating portion of the second connecting rod, so that the second axis rotates relative to the base and drives the rotating portion of the third connecting rod to move, to drive the movable plate to slide relative to the main swing arm. The movable plate slides relative to the main swing arm under driving of the main swing arm and the compensation mechanism, to generate displacement in a direction toward or away from the base, so as to change a distance between the movable plate and the base.

Further, the first housing and the second housing of the foldable electronic device also generate displacement in the direction toward or away from the base under driving of the movable plates, and an overall length of the foldable apparatus including the first housing, the second housing, and the hinge apparatus is also adjusted, to adapt to different forms of a display screen. In an inward folding electronic device, when the foldable electronic device is in an unfolded state, a distance between a movable plate of each hinge assembly and a base is short, and an overall length of a foldable apparatus is short. When the foldable electronic device is in a folded state, a distance between the movable plate of each hinge assembly and the base is long, and an overall length of the foldable apparatus is long, to adapt to a length of a display screen, and avoid stretching or squeezing of the display screen.

It can be learned that through the hinge apparatus provided in this application, a length of the foldable apparatus in the foldable electronic device can be adjusted, to avoid squeezing or stretching of the display screen in a process of folding and unfolding, and avoid damage on the display screen.

Further, the three connecting rods in the compensation mechanism rotate around the second axis together, that is, share one concentric axis, so that the structure is stable, an assembly error is small, and movement track accuracy of each connecting rod is high. In addition, an overall structure of the compensation mechanism is compact, and the compensation mechanism occupies small space and can be disposed below the display screen (that is, disposed in mounting space between the display screen and the base, and the compensation mechanism does not need to be disposed on two sides of the base in a length direction of the base to avoid the display screen), thereby facilitating a narrow-bezel design of the foldable electronic device and maximizing the display screen.

In some embodiments, each hinge assembly further includes an eccentric shaft. The rotating portion of the second connecting rod is mounted on the main shaft through the eccentric shaft and is rotatably connected to the main shaft. The eccentric shaft penetrates the main shaft, the rotating portion of the second connecting rod is disposed as a sleeve structure and is sleeved on an outer circumference of the eccentric shaft, and when the rotating portion of the second connecting rod rotates around the first axis relative to the base under driving of the main swing arm, the second connecting rod rotates around a fifth axis relative to the main shaft. The fifth axis is an axis of the eccentric shaft and is parallel to the first axis.

According to the foregoing solution, the second connecting rod is connected to the main shaft through the physical shaft, connection strength between the eccentric shaft and the main shaft is high, stability is high, and movement track accuracy of the rotating portion of the second connecting rod is high.

In some embodiments, a shaft hole is provided on the main shaft, the shaft hole and an axis of the main shaft are spaced apart in a radial direction of the main shaft, and the eccentric shaft passes through the shaft hole. The shaft hole is provided on an outer wall surface of the main shaft, a notch is formed on the outer wall surface of the main shaft, and a partial structure of the eccentric shaft is embedded in the main shaft in the radial direction of the main shaft. The notch is provided on the outer wall surface of the main shaft to facilitate mounting of the eccentric shaft on the main shaft.

In some embodiments, in each hinge assembly, the third axis is located, in the first direction, on a side that is of the first axis and that is close to another hinge assembly.

According to the foregoing solution, the third axis of the first hinge assembly and the third axis of the second hinge assembly may coincide and may be shared, thereby saving space.

In some embodiments, in each hinge assembly, the concentric portion of the first connecting rod includes a first connecting portion, the concentric portion of the second connecting rod includes two second connecting portions spaced apart in the second direction, and the concentric portion of the third connecting rod includes two third connecting portions spaced apart in the second direction.

In the second direction, the two third connecting portions of the third connecting rod are disposed between the two second connecting portions of the second connecting rod, and the first connecting portion of the first connecting rod is disposed between the two third connecting portions of the third connecting rod.

The compensation mechanism further includes a concentric shaft. Each of the first connecting portion, the two second connecting portions, and the two third connecting portions is disposed as a sleeve structure, all the connecting portions are coaxially disposed in the second direction, and the concentric shaft penetrates all the connecting portions, so that any two connecting rods rotate relative to each other around the second axis.

According to the foregoing solution, all the connecting rods are connected through concentric shafts, the structure is stable, an assembly error is small, and movement track accuracy of the connecting rods is high.

In some embodiments, the rotating portion of the first connecting rod is connected to the first connecting portion through a first connecting plate, the rotating portion of the second connecting rod is connected to the two second connecting portions through a second connecting plate, and the rotating portion of the third connecting rod is connected to the two third connecting portions through a third connecting plate. The first connecting plate, the second connecting plate, and the third connecting plate each are disposed as a plate structure.

According to the foregoing solution, the plate structure is stable, is not easy to deform, and has high reliability. In addition, a connecting rod of a plate structure may be processed into a bent shape based on a shape and a location of each component in an actual product, to avoid another structural member, for example, avoid an appearance member on a base. This reduces openings on the appearance member, so that a product has a complete appearance.

In some embodiments, the rotating portion of the first connecting rod, the first connecting portion, and the first connecting plate are disposed as an integrated structure. The rotating portion of the second connecting rod, the two second connecting portions, and the second connecting plate are disposed as an integrated structure. The rotating portion of the third connecting rod, the two third connecting portions, and the third connecting plate are disposed as an integrated structure.

All the connecting rods are integrally formed and are more secure. This simplifies production and mounting processes.

In some embodiments, the main swing arm includes a main body portion and two connecting arms connected to the main body portion. The two connecting arms are fastened to the main shaft, and the main shaft rotates around the first axis relative to the base under driving of the main swing arm, so that the main swing arm rotates around the first axis relative to the base. The movable plate includes a body portion and a rotatable connecting member connected to the body portion. The rotatable connecting member is rotatably connected to the rotating portion of the third connecting rod, so that the third connecting rod is rotatably connected to the movable plate.

The main body portion of the main swing arm and the body portion of the movable plate are stacked and are slidably connected through at least one sliding structure. Each sliding structure in the at least one sliding structure includes a slide rail and a sliding block that are slidably connected to each other, one of the slide rail and the sliding block is disposed on the body portion of the movable plate, and the other of the slide rail and the sliding block is disposed on the main body portion of the main swing arm.

According to the foregoing solution, the main swing arm and the movable plate are connected through a sliding structure, so that the main swing arm and the movable plate slide relative to each other.

In some embodiments, the main shaft includes a first shaft body and a second shaft body that are spaced apart in the second direction. Each of the two connecting arms of the main swing arm is disposed as a sleeve structure, one of the two connecting arms is sleeved and fastened on the first shaft body, and the other of the two connecting arms is sleeved and fastened on the second shaft body. When each hinge assembly rotates relative to the base, the first shaft body and the second shaft body of the main shaft rotate synchronously.

A first hollow portion is disposed on the main body portion of the main swing arm, and the first hollow portion is located between the two connecting arms in the second direction and is in communication with space between the two connecting arms, so that the two connecting arms and the main body portion enclose accommodating space, and the entire compensation mechanism is located in the accommodating space.

According to the foregoing solution, the main shaft is divided into two parts and the first hollow portion is disposed on the main swing arm to avoid a structure of the compensation mechanism, and the compensation mechanism is accommodated in a cavity between the main shaft and the main swing arm, so that the overall structure of the hinge apparatus is more compact, to save space.

In some possible embodiments, the rotatable connecting member of the movable plate includes two rotating arms spaced apart in the second direction. The rotating portion of the third connecting rod is disposed between the two rotating arms.

All the rotating portion of the third connecting rod and the two connecting arms of the movable plate are disposed as sleeve structures and are coaxially disposed in the second direction. The compensation mechanism further includes a rotatable connecting shaft. The rotatable connecting shaft penetrates the rotating portion of the third connecting rod and the two connecting arms of the movable plate, so that the third connecting rod is rotatably connected to the movable plate.

In some embodiments, the main body portion of the main swing arm is slidably connected to the body portion of the movable plate through two sliding structures. A first bump, a second bump, and a third bump that are sequentially spaced apart in the second direction are disposed on the body portion of the movable plate, and each of the first bump, the second bump, and the third bump protrudes from the body portion toward a side close to the main swing arm. The entire main body portion of the main swing arm is located between the first bump and the third bump in the second direction. In addition, a groove corresponding to the second bump is provided on the main body portion, and the second bump is embedded in the groove and slides in the groove.

In the second direction, one slide rail is formed between the first bump and the second bump, one slide rail is formed between the second bump and the third bump, parts that are of the main body portion of the main swing arm and that are located on two sides of the groove each form one sliding block, and each sliding block is in one-to-one correspondence with each slide rail. The main body portion is designed as a sliding block. The structure is simple, and an area of sliding connection between the main swing arm and the movable plate is large.

In some embodiments, each hinge assembly further includes a support plate. The support plate is configured to support a display screen of a foldable electronic device and is stacked on a side that is of the movable plate and that faces away from the main swing arm.

The support plate is separately slidably connected to the movable plate and the main swing arm. When the main swing arm rotates around the first axis relative to the base, the support plate slides relative to the main swing arm under driving of the movable plate and slides relative to the movable plate along an arc-shaped track, so that the support plate rotates around a sixth axis relative to the movable plate, where the sixth axis extends in the second direction.

According to the foregoing solution, in a rotation process of the main swing arm, in addition to sliding relative to the main swing arm along with the movable plate, the support plate further rotates relative to the movable plate, so that different angles are presented between the support plate and the movable plate, to support the display screen in different states.

In some embodiments, the support plate includes a plate body, a first boss, and two second bosses respectively located on two sides of the first boss in the second direction. Each of the first boss and the two second bosses is connected to the plate body and protrudes from the plate body toward a side close to the main swing arm.

The main swing arm includes a connecting boss protruding from the main body portion toward a side close to the support plate, a second hollow portion is disposed on the body portion of the movable plate, and both the connecting boss of the main swing arm and the first boss of the support plate are accommodated in the second hollow portion of the movable plate and are slidably connected to each other, so that the support plate is slidably connected to the movable plate. The movable plate is stacked between the main swing arm and the support plate. To avoid a connecting member between the main swing arm and the support plate, a corresponding location on the movable plate is hollowed out.

The entire movable plate is located between the two second bosses of the support plate in the second direction, arc-shaped slide rails are disposed at two ends of the movable plate, and each of the two second bosses is disposed as an arc-shaped structure and slides in a corresponding arc-shaped slide rail, so that the support plate slides relative to the movable plate along the arc-shaped track.

In some embodiments, an arc-shaped hole is provided on the first boss of the support plate, and the arc-shaped hole extends through the first boss in the second direction and extends along an arc line in a plane perpendicular to the second direction. The connecting boss of the main swing arm includes two connecting brackets spaced apart in the second direction, and the first boss is located between the two connecting brackets.

The connecting boss of the main swing arm further includes a sliding rod. Two ends of the sliding rod are mounted on the two connecting brackets, the sliding rod passes through the arc-shaped hole of the first boss, and the sliding rod slides in the arc-shaped hole, so that the support plate slides relative to the main swing arm along an arc-shaped track.

In some embodiments, the hinge apparatus further includes a fastened bracket disposed on the base. The rotating portion of the first connecting rod in each hinge assembly is rotatably connected to the fastened bracket, so that the first connecting rod in each hinge assembly is rotatably connected to the base, and the third axes of all the hinge assemblies coincide.

According to the foregoing solution, the first hinge assembly and the second hinge assembly share one third axis. This design is compact, and space occupied by the hinge apparatus in the first direction is reduced.

In some embodiments, the fastened bracket includes a first bracket and a second bracket that are spaced apart in the second direction. The rotating portion of the first connecting rod in each hinge assembly is disposed between the first bracket and the second bracket. In addition, the rotating portion of the first connecting rod in the first hinge assembly is rotatably connected to the first bracket, and the rotating portion of the second connecting rod in the second hinge assembly is rotatably connected to the second bracket.

The hinge apparatus further includes a fastened shaft. All the first bracket, the second bracket, and the rotating portion of the first connecting rod in each hinge assembly are disposed as sleeve structures and are coaxially disposed in the second direction. The fastened shaft sequentially penetrates the first bracket, the rotating portion of the first connecting rod in the first hinge assembly, the rotating portion of the first connecting rod in the second hinge assembly, and the second bracket, so that the first connecting rod in each hinge assembly is rotatably connected to the base.

In some embodiments, the base includes a bottom plate, a first side wall and a second side wall that are disposed opposite to each other in the first direction, and a third side wall and a fourth side wall that are disposed opposite to each other in the second direction. The bottom plate, the first side wall, the second side wall, the third side wall, and the fourth side wall enclose an accommodating groove, the main shaft in each hinge assembly is disposed in the accommodating groove, and a part of the compensation mechanism is located in the accommodating groove.

The base further includes a cover plate. The cover plate is disposed opposite to the bottom plate in a third direction and is configured to support the display screen of the foldable electronic device, where the third direction is perpendicular to the first direction and is perpendicular to the second direction.

The cover plate is configured to support a foldable part of the display screen. When the foldable electronic device is in an unfolded state, the support plate of each hinge assembly is connected to the cover plate of the base to form a flat plate structure, to jointly support all parts of the display screen.

In some embodiments, the hinge apparatus further includes a first damping structure and a second damping structure. The first damping structure and the second damping structure are respectively disposed on two sides of the base in the first direction.

Each of the first damping structure and the second damping structure includes a damping shaft and a damping swing arm. The damping shaft is rotatably connected to the base, and the damping swing arm is fastened to the damping shaft, so that the damping swing arm is rotatably connected to the base through the damping shaft. The damping swing arm of the first damping structure is fastened to the main swing arm of the first hinge assembly, so that the damping swing arm of the first damping structure rotates around the first axis of the first hinge assembly relative to the base under driving of the main swing arm. The damping swing arm of the second damping structure is fastened to the main swing arm of the second hinge assembly, so that the damping swing arm of the second damping structure rotates around the first axis of the second hinge assembly relative to the base under driving of the main swing arm.

Each damping structure further includes at least one damping module. Each damping module in the at least one damping module includes an elastic member, a first gear, and a shaft sleeve that separately penetrate the damping shaft. The shaft sleeve is disposed between the elastic member and the first gear in the second direction, the shaft sleeve is sleeved on the damping shaft, and the first gear is disposed on the damping shaft and is fixed relative to the damping shaft, so that the first gear rotates relative to the base and rotates relative to the shaft sleeve under driving of the damping shaft.

The first gear includes a first end surface facing the shaft sleeve. The shaft sleeve includes a second end surface facing the first gear. The elastic member applies an elastic force to the shaft sleeve and the first gear through deformation of the elastic member, so that the first end surface and the second end surface are mutually squeezed.

According to the foregoing solution, the damping structure may generate a damping force, so that the foldable electronic device can hover at a specific angle in a process of unfolding or folding.

In some embodiments, each damping structure includes two damping modules. The two damping modules are respectively disposed on two sides of the damping swing arm in the second direction, and the elastic member of each damping module is disposed on a side that is of the shaft sleeve and that is away from the damping swing arm. In each damping module, one end that is of the elastic member and that is away from the damping swing arm is fixed relative to the base, and the other end of the elastic member is configured to squeeze the shaft sleeve and the first gear.

In some embodiments, first gears of the first damping structure and the second damping structure are disposed in one-to-one correspondence in the second direction. A synchronization mechanism is disposed between each pair of first gears corresponding to each other, and the synchronization mechanism includes a second gear and a third gear that are meshed with each other. The second gear is meshed with one first gear, the third gear is meshed with the other first gear. When the damping swing arm of any one of the damping structures rotates under driving of a corresponding hinge assembly, the damping swing arm drives, through the synchronization mechanism, the damping swing arm of the other damping structure to rotate, so that the first hinge assembly and the second hinge assembly rotate synchronously.

According to the foregoing solution, when a user rotates a structure on a side of the foldable electronic device, a structure on the other side also rotates synchronously under an action of the synchronization mechanism, which is more convenient in use and improves customer experience.

An embodiment of this application further provides a foldable apparatus, including a first housing, a second housing, and the hinge apparatus provided in any one of the foregoing embodiments. The first housing and the second housing are respectively disposed on two sides of the hinge apparatus in the first direction. The movable plate of the first hinge assembly is fastened to the first housing, the movable plate of the second hinge assembly is fastened to the second housing, and the first housing and the second housing generate displacement in a direction toward or away from the base when rotating relative to each other.

According to the foldable apparatus provided in this embodiment of this application, a length can be adjusted in a process of unfolding and folding a foldable electronic device, to adapt to different forms of a display screen, and avoid stretching or squeezing of the display screen.

An embodiment of this application further provides a foldable electronic device, including a display screen, and further including the foldable apparatus provided in any one of the foregoing embodiments. The display screen is laid on the foldable apparatus. When the foldable electronic device is in a folded state, the foldable apparatus surrounds an outer side of the display screen.

According to the foldable electronic device provided in this embodiment of this application, a length of a foldable apparatus can be adjusted in a process of unfolding and folding, to adapt to different forms of a display screen, and avoid stretching or squeezing of the display screen.

### BRIEF DESCRIPTION OF DRAWINGS

FIG. 1 is a diagram of a structure of a foldable electronic device in an unfolded state;
FIG. 2 is a diagram of a structure of a foldable electronic device in a folded state;
FIG. 3a is a diagram of a structure of a foldable electronic device in an unfolded state according to an embodiment of this application;
FIG. 3b is a diagram of a structure of a foldable electronic device in a folded state according to an embodiment of this application;
FIG. 3c is an exploded view of a structure of a foldable electronic device according to an embodiment of this application;
FIG. 4 and FIG. 5 are diagrams of a principle structure of a hinge apparatus according to embodiments of this application, where FIG. 4 corresponds to an unfolded state of a foldable electronic device, and FIG. 5 corresponds to a folded state of the foldable electronic device;
FIG. 6a is a diagram of a three-dimensional structure of a hinge apparatus according to an embodiment of this application;
FIG. 6b is a top view of a structure of a hinge apparatus according to an embodiment of this application;
FIG. 6c is a partially enlarged view of a part G in FIG. 6b;
FIG. 7a is a diagram of a structure of a hinge apparatus in which a support plate is removed according to an embodiment of this application;
FIG. 7b is a partially enlarged view of a part H in FIG. 7a;
FIG. 7c is a diagram of a structure in which a cover plate is removed in FIG. 7b;
FIG. 7d is a partially enlarged view of a part C in FIG. 7c;
FIG. 8a is an exploded view of a structure of a hinge apparatus according to an embodiment of this application;
FIG. 8b is a partially enlarged view of a part E in FIG. 8a;
FIG. 9a and FIG. 9b are cross-sectional views in an A-A direction in FIG. 7d, where FIG. 9a corresponds to a folded state of a foldable electronic device, and FIG. 9b corresponds to an unfolded state of the foldable electronic device;
FIG. 10a and FIG. 10b are cross-sectional views of a structure of a foldable apparatus according to an embodiment of this application, where FIG. 10a corresponds to a folded state of a foldable electronic device, FIG. 10b corresponds to an unfolded state of the foldable electronic device, and cross-sectional locations in FIG. 10a and FIG. 10b are consistent with those in FIG. 9a and FIG. 9b;
FIG. 11a and FIG. 11b are cross-sectional views in a B-B direction in FIG. 7d, where FIG. 11a corresponds to a folded state of a foldable electronic device, and FIG. 11b corresponds to an unfolded state of the foldable electronic device;
FIG. 12 is a diagram of a structure of a compensation mechanism in a hinge apparatus according to an embodiment of this application;
FIG. 13 is an exploded view of a structure of a compensation mechanism in a hinge apparatus according to an embodiment of this application;
FIG. 14 is a diagram of a structure of a main swing arm in a hinge apparatus according to an embodiment of this application;
FIG. 15 is a diagram of an assembly structure of a movable plate and a third connecting rod in a hinge apparatus according to an embodiment of this application;
FIG. 16 is a diagram of an assembly structure of a main swing arm and a movable plate in a hinge apparatus according to an embodiment of this application;
FIG. 17 is a diagram of an assembly structure of a main swing arm and a movable plate with a connecting rod in a hinge apparatus according to an embodiment of this application;
FIG. 18 is a diagram of an assembly structure of a main swing arm, a movable plate, and a support plate in a hinge apparatus according to an embodiment of this application;
FIG. 19 is an exploded view of a structure of a main swing arm, a movable plate, and a support plate in a hinge apparatus according to an embodiment of this application;
FIG. 20 is a diagram of an assembly structure of a support plate and a movable plate in a hinge apparatus according to an embodiment of this application;
FIG. 21 is a diagram of an assembly structure of a support plate and a main swing arm in a hinge apparatus according to an embodiment of this application;
FIG. 22 is a partially enlarged view of a part D in FIG. 7c;
FIG. 23 is a diagram of a three-dimensional structure of a damping structure in a hinge apparatus according to an embodiment of this application; and
FIG. 24 is an exploded view of a structure of a damping structure in a hinge apparatus according to an embodiment of this application.

### Reference numerals:

100': foldable electronic device;
1': foldable apparatus; 11': first housing; 12': second housing; 13': hinge apparatus;
2': display screen; and 21': foldable part.

In this application:
100: hinge apparatus;
1: base; 10: accommodating groove; 11: first side wall; 12: second side wall;
13: third side wall; 14: fourth side wall; 15: bottom plate; 16: cover plate;
21: first hinge assembly; 22: second hinge assembly;
23: main shaft; 230: shaft hole; 231: first shaft body; 232: second shaft body;
24: eccentric shaft; 25: concentric shaft; 26: rotatable connecting shaft;
27: fastened bracket; 271: first bracket; 272: second bracket;
281: first fastened base; 282: second fastened base;
3: compensation mechanism;
31: first connecting rod; 311: concentric portion; 3111: first connecting portion; 312: rotating portion; 313: first connecting plate;
32: second connecting rod; 321: concentric portion; 3211: second connecting portion; 322: rotating portion; 323: second connecting plate;
33: third connecting rod; 331: concentric portion; 3311: third connecting portion; 332: rotating portion; 333: third connecting plate;
4: main swing arm; 41: main body portion; 411: first hollow portion; 412: groove; 42: connecting arm; 43: sliding block;
44: connecting boss; 441: connecting bracket. 442: sliding rod;
5: movable plate; 51: body portion; 511: first bump; 512: second bump; 513: third bump; 514: second hollow portion;
52: rotatable connecting member; 521: rotating arm; 53: slide rail; 54: arc-shaped slide rail;
6: support plate; 61: plate body; 62: first boss; 620: arc-shaped hole; 63: second boss;
71: first damping structure; 72: second damping structure;
73: damping shaft; 74: damping swing arm; 741: fastening plate; 742: rotation arm;
75: damping module; 751: elastic member; 752: first gear; 7521: first end surface;
753: shaft sleeve; 7531: second end surface;
76: synchronization mechanism; 761: second gear; 762: third gear;
200: foldable apparatus;
81: first housing; 82: second housing;
300: foldable electronic device;
9: display screen; 91: first part; 92: second part; 93: foldable part;
Q1: first axis; Q2: second axis; Q3: third axis;
Q4: fourth axis; Q5: fifth axis; Q6: sixth axis;
X: first direction; Y: second direction; and Z: third direction.

### DESCRIPTION OF EMBODIMENTS

The following describes implementations of this application by using specific embodiments. A person skilled in the art may easily learn of other advantages and effects of this application based on content disclosed in this specification. Although this application is described with reference to some embodiments, it does not mean that a characteristic of this application is limited only to this implementation. On the contrary, a purpose of describing this application with reference to an implementation is to cover another option or modification that may be derived based on claims of this application. To provide an in-depth understanding of this application, the following descriptions include a plurality of details. This application may alternatively be implemented without using these details. In addition, to avoid confusion or blurring a focus of this application, some details are omitted from the description. It should be noted that embodiments of this application and the features in embodiments may be mutually combined in the case of no conflict.

It should be noted that, in this specification, similar reference numerals and letters in the following accompanying drawings represent similar items. Therefore, once an item is defined in an accompanying drawing, the item does not need to be further defined or interpreted in the following accompanying drawings.

In the descriptions of this application, it should be noted that orientations or position relationships indicated by terms "center", "upper", "lower", "left", "right", "vertical", "horizontal", "inner", "outer", "top", "bottom" and the like are orientations or position relationships shown based on the accompanying drawings, and are merely used for ease of describing this application and simplifying the descriptions, rather than indicating or implying that a described apparatus or element needs to have a specific orientation or needs to be constructed and operated in a specific orientation, and therefore cannot be understood as a limitation on this application. In addition, terms "first" and "second" are merely used for a purpose of description, and shall not be understood as an indication or implication of relative importance.

In descriptions of this application, it should be noted that unless otherwise expressly specified and limited, terms "mount", "interconnect", and "connect" should be understood in a broad sense. For example, the terms may indicate a fixed connection, a detachable connection, or an integral connection; may be a mechanical connection or an electrical connection; or may be direct interconnection, indirect interconnection through an intermediate medium, or communication between the interior of two elements. For a person of ordinary skill in the art, a specific meaning of the foregoing terms in this application may be understood based on a specific situation.

In descriptions of this application, it should be understood that, in this application, an "electrical connection" may be understood as physical contact and electrical conduction of components, or may be understood as a form in which different components in a circuit structure are connected through a physical line that can transmit an electrical signal, such as printed circuit board (printed circuit board, PCB) copper foil or a conducting wire.

In the descriptions of this application, it should be noted that mutual perpendicularity in this application is not absolute perpendicularity, and approximate perpendicularity (for example, an included angle between two structural features is 89.9°) caused by a processing error and an assembly error is also in a range of mutual perpendicularity in this application. Mutual parallelism in this application is not absolute parallelism, and approximate parallelism (for example, an included angle between two structural features is 0.1°) caused by a processing error and an assembly error is also in a range of mutual parallelism in this application. Axial symmetry in this application is not absolute axial symmetry, and approximate axial symmetry (for example, a partial structure is offset by a specific distance or angle relative to a symmetry axis) caused by a processing error and an assembly error is also in a range of axial symmetry in this application. Central symmetry in this application is not absolute central symmetry, and approximate central symmetry (for example, a partial structure is offset by a specific distance or angle relative to a symmetry axis) caused by a processing error and an assembly error is also in a range of central symmetry in this application. This is not specifically limited in this application.

To make the objectives, technical solutions, and advantages of this application clearer, the following further describes the implementations of this application in detail with reference to the accompanying drawings.

With the development of flexible display screens, foldability becomes an important direction for electronic device development. A foldable electronic device includes two parts that can rotate relative to each other. The two parts are rotatably connected through a hinge apparatus, to implement folding and unfolding of the foldable electronic device, to meet requirements of different use scenarios. The entire foldable electronic device includes a foldable apparatus (also referred to as a housing assembly, where the hinge apparatus is disposed in the foldable apparatus) and a display screen. The display screen is laid on a side of the foldable apparatus. When the foldable electronic device is folded and unfolded, the display screen is folded and unfolded together with the foldable apparatus. However, because the foldable apparatus and the display screen are stacked, and each have a specific thickness, a path difference exists between the display screen and the foldable apparatus in a process of folding and unfolding. A length of the foldable apparatus needs to be adjusted in a process of unfolding and folding the foldable electronic device to adapt to different forms of the display screen. In an actual product, two ends of a display screen are usually fastened on a foldable apparatus. If a length of the foldable apparatus cannot be adjusted in a process of folding and unfolding, the display screen is squeezed or stretched, damaging the display screen.

To more clearly describe the path difference between the display screen and the foldable apparatus in the process of unfolding and folding, the following performs analysis with reference to a structure of an inward folding electronic device.

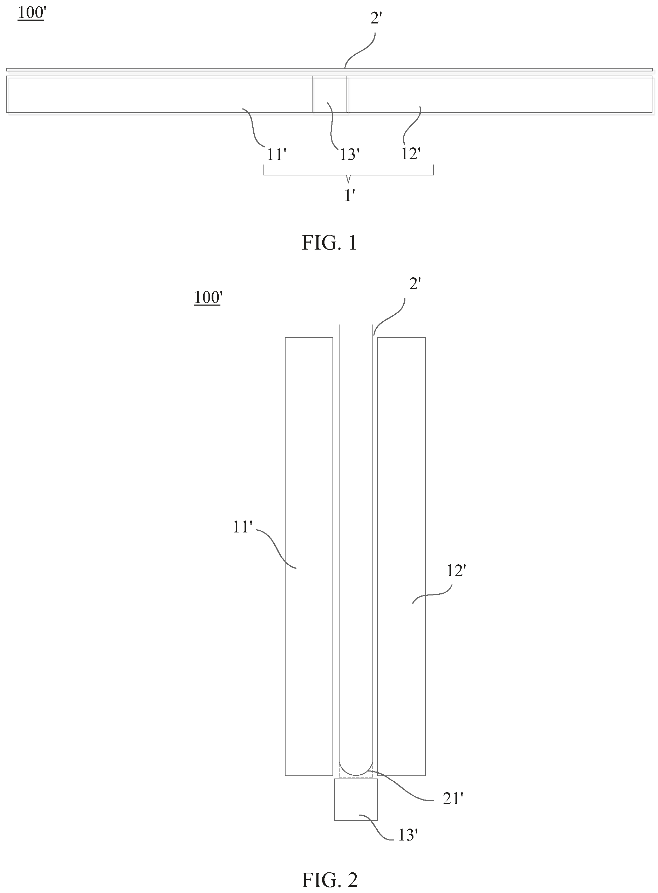

FIG. 1 is a diagram of a structure of a foldable electronic device in an unfolded state. FIG. 2 is a diagram of a structure of a foldable electronic device in a folded state.

As shown in FIG. 1 and FIG. 2, the foldable electronic device 100' includes a foldable apparatus 1' and a display screen 2' laid on the foldable apparatus 1'. The foldable apparatus 1' includes a first housing 11', a second housing 12', and a hinge apparatus 13'. It is assumed that the display screen 2' and the foldable apparatus 1' are not fastened. When the foldable electronic device 100' is in an unfolded state, lengths of the display screen 2' and the foldable apparatus 1' are consistent. In this case, the first housing 11' and the second housing 12' rotate, to switch the foldable electronic device 100' to a folded state. A foldable part 21' of the display screen 2', that is, a part that is of the display screen 2' and that is stacked on the hinge apparatus 13', is folded in a curved form (where a common curved form includes an arc shape, a water drop shape, and the like, and the arc shape is used as an example in the figure).

When the overall length of the foldable apparatus 1' is unchanged, the foldable apparatus 1' is bent in a straight corner shape, and the foldable part 21' of the display screen 2' cannot fit into the bent form of the foldable apparatus 1'. Therefore, after the foldable electronic device 100' is folded, a state shown in FIG. 2 is presented, the display screen 2' and the foldable apparatus 1' are misaligned, and two ends of the display screen 2' protrude from the foldable apparatus 1'. It can be learned that a folding path difference exists between the display screen 2' and the foldable apparatus 1'. In an actual scenario, the two ends of the display screen 2' are respectively fastened on the first housing 11' and the second housing 12'. In this case, during folding and unfolding, a shape of the display screen 2' needs to be changed, to adapt to different forms of the foldable apparatus 1'. As a result, the display screen 2' is squeezed or stretched. For example, assuming that the length of the display screen 2' exactly matches the length of the foldable apparatus 1' in the unfolded state, the display screen 2' is squeezed in the folded state. In other words, assuming that the length of the display screen 2' exactly matches the length of the foldable apparatus 1' in the folded state, the display screen 2' is stretched in the unfolded state. In either case, the display screen 2' is damaged.

It can be learned that, in the conventional technology, a length of a foldable apparatus in a foldable electronic device cannot be adjusted. As a result, a display screen is squeezed or stretched in a process of folding and unfolding and faces a risk of damage.

To resolve the foregoing technical problem, an embodiment of this application provides a hinge apparatus. A compensation mechanism is disposed in the hinge apparatus, and a length of a foldable apparatus is adjusted in a process of unfolding and folding a foldable electronic device, to avoid stretching or squeezing of a display screen. In addition, a structure of the compensation mechanism is stable, an assembly error is small, and movement track accuracy is high. In addition, an overall structure of the compensation mechanism is compact, and the compensation mechanism occupies small space, thereby facilitating a narrow-bezel design of the foldable electronic device and maximizing the display screen.

This application further provides a foldable electronic device. The foldable electronic device may be, but is not limited to, a foldable electronic product such as a mobile phone, a tablet computer, a notebook computer, or a wearable device. A specific form of the foldable electronic device is not specially limited in embodiments of this application. For ease of description, a mobile phone is used as an example below for description.

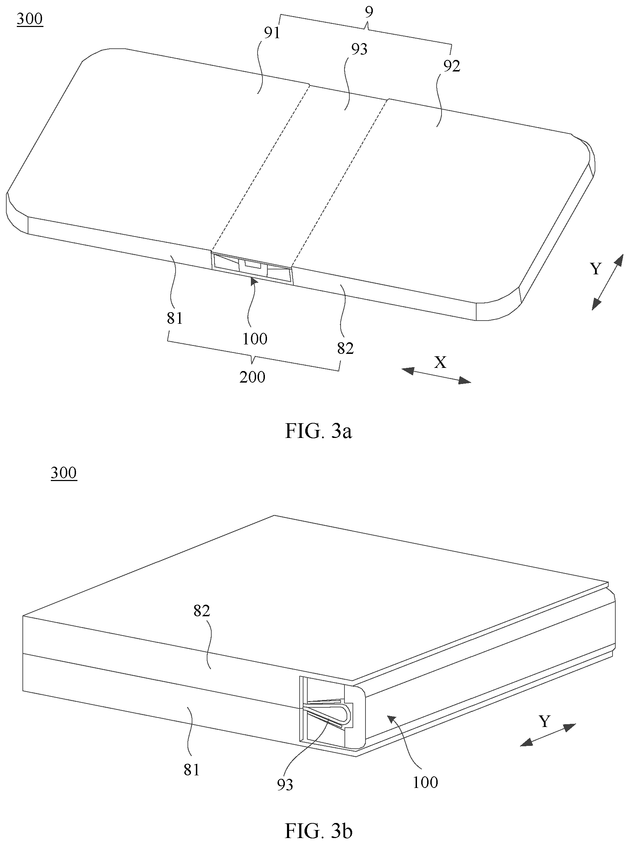

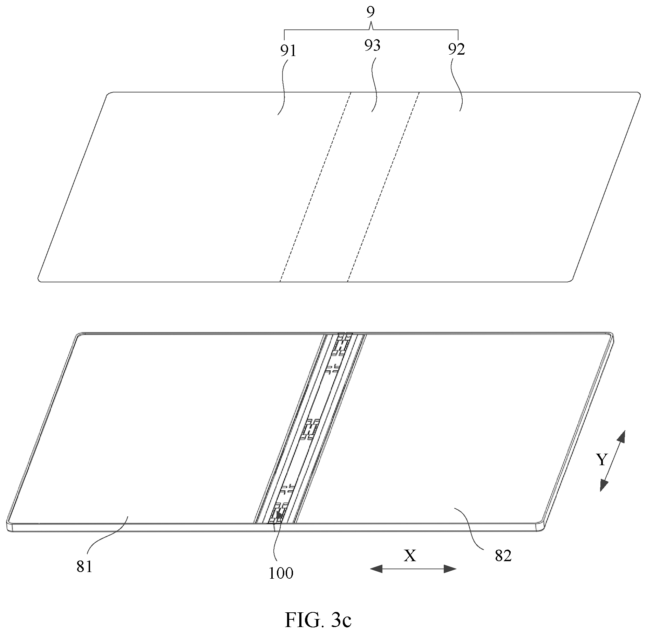

FIG. 3a is a diagram of a structure of a foldable electronic device in an unfolded state according to an embodiment of this application. FIG. 3b is a diagram of a structure of a foldable electronic device in a folded state according to an embodiment of this application. FIG. 3c is an exploded view of a structure of a foldable electronic device according to an embodiment of this application.

As shown in FIG. 3a to FIG. 3c, the foldable electronic device 300 includes a display screen 9 and a foldable apparatus 200. The display screen 9 is laid on a side of the foldable apparatus 200. The display screen 9 is configured to perform imaging and human-machine interaction, and may be, but is not limited to, an organic light-emitting diode (organic light-emitting diode, OLED) display screen, an active-matrix organic light-emitting diode (active-matrix organic light-emitting diode, AMOLED) display screen, a quantum dot light-emitting diode (quantum dot light-emitting diode, QLED) display screen, or the like. This is not limited in this application. The display screen 9 is connected to a surface on the side of the foldable apparatus 200. A surface that is of the display screen 9 and that faces away from the foldable apparatus 200 is a display surface of the display screen 9, and the display surface is configured to display information and provide an interaction interface for a user.

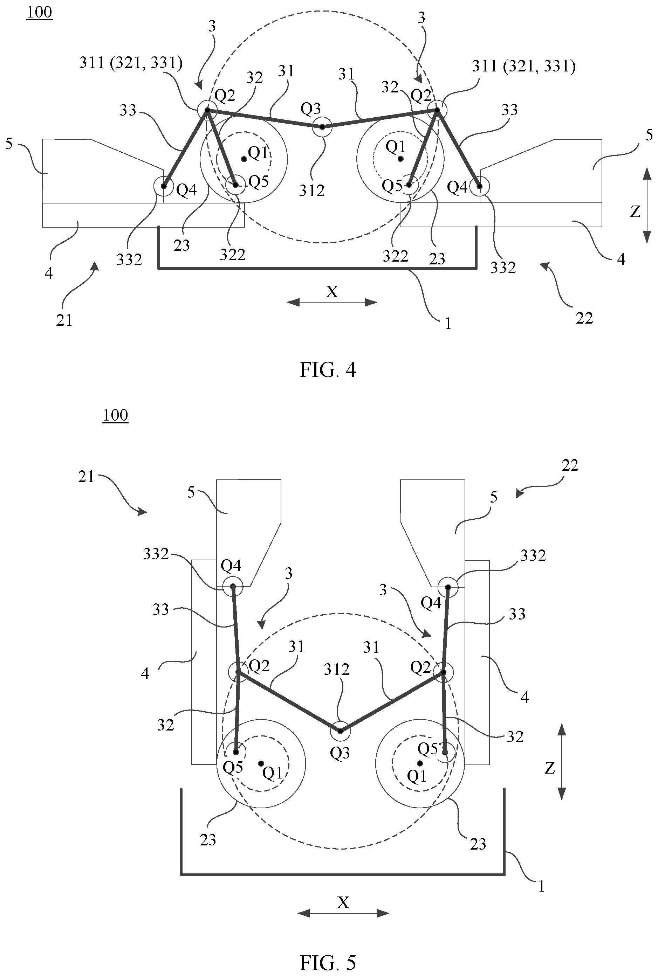

The foldable apparatus 200 is also referred to as a housing assembly, and is configured to carry and accommodate the display screen 9 and other electronic components. The foldable apparatus 200 includes a first housing 81, a second housing 82, and a hinge apparatus 100. The first housing 81 and the second housing 82 are respectively disposed on two sides of the hinge apparatus 100 in a first direction X. The first direction X may be a width direction of a base 1 of the hinge apparatus 100 (with reference to FIG. 4, and the base 1 is described in detail below), or a length direction of the foldable electronic device 300 in an unfolded state. The first housing 81 and the second housing 82 are configured to mount the display screen 9 and various electronic components. The hinge apparatus 100 is configured to rotatably connect the first housing 81 and the second housing 82, to fold and unfold the foldable electronic device 300. In an implementation, the first housing 81 and the second housing 82 each have accommodating space, to accommodate some electronic components. The electronic component includes, but is not limited to, a circuit board, a battery, a camera module, a microphone, a speaker, and the like. This is not limited in this application.

The foldable electronic device 300 has a folded state and an unfolded state. For example, as shown in FIG. 3a, when the foldable electronic device 300 is in the unfolded state, an angle at which the foldable electronic device 300 is opened is 180°, that is, an angle between the first housing 81 and the second housing 82 is 180°. A person skilled in the art may understand that the angle at which the foldable electronic device 300 is opened may alternatively be 90°, 120°, 210°, or the like. This is not limited in this application. In addition, slight deviations are allowed for angles described as examples in this application. For example, when the foldable electronic device 300 is in an open state, an angle at which the foldable electronic device 300 is opened may be 180°, or may be approximately 180°, for example, 170°, 175°, 185°, or 190°. Same understanding may also be performed on other angles in the following. When the first housing 81 and the second housing 82 rotate relative to each other and are stacked on each other, the foldable electronic device 300 is in a closed state shown in FIG. 3b. In this case, an angle between the first housing 81 and the second housing 82 may be considered as approximately 0°. In an implementation, the foldable electronic device 300 is an inward folding electronic device. When the foldable electronic device 300 is in the folded state, the entire foldable apparatus 200 surrounds an outer side of the display screen 9.

It should be noted that a specific structure of the display screen 9 is not limited. In an implementation, the display screen 9 includes a first part 91, a second part 92, and a foldable part 93. The first part 91 is fastened to the first housing 81, the second part 92 is fastened to the second housing 82, and the foldable part 93 is located between the first part 91 and the second part 92 and is stacked on the hinge apparatus 100. In a process of using the foldable electronic device 300, the first part 91 and the second part 92 are always in a planar state, and the foldable part 93 may be bent, to change an angle between the first part 91 and the second part 92, so that the display screen 9 is folded or unfolded as the foldable apparatus 200 moves. For example, the foldable part 93 may be made of a flexible material, so that the foldable part 93 is bendable.

It should be noted that when the foldable electronic device 300 is in the folded state, a bent form of the foldable part 93 of the display screen 9 is not limited. As shown in FIG. 3b, in an implementation, the foldable part 93 of the display screen 9 is bent in a water drop shape, so that the foldable part 93 of the display screen 9 has a large bending radius. Therefore, the display screen 9 is not prone to "stress relaxation" in a long-time bending state, and a risk that a crease occurs on the display screen 9 during unfolding is reduced. In another alternative implementation, the foldable part 93 of the display screen 9 may alternatively be bent in an arc shape or the like, which is not enumerated in this application.

In an implementation, when the foldable electronic device 300 is in the folded state, the hinge apparatus 100 avoids the display screen 9 and forms accommodating space in a direction facing away from the display screen 9, so that the foldable part 93 of the flexible display screen 9 can be accommodated in the accommodating space formed by the hinge apparatus 100, and the hinge apparatus 100 further limits and protects the foldable part 93 of the flexible display screen 9, to avoid a case in which the foldable part 93 of the display screen 9 is excessively deformed when the foldable part 93 is subjected to external impact, and consequently an obvious crease or direct damage is generated.

Further, in the foldable apparatus 200, when the first housing 81 and the second housing 82 rotate relative to each other, the first housing 81 and the second housing 82 generate displacement in a direction toward or away from the hinge apparatus 100, to adjust an overall length of the foldable apparatus 200, so as to adapt to different forms of the display screen 9, and avoid squeezing or stretching of the display screen 9 in a process of unfolding and folding. The following describes a structure and a working principle of the hinge apparatus 100 with reference to the accompanying drawings, so as to more clearly describe an adjustment function of the hinge apparatus 100 on the length of the foldable apparatus 200.

FIG. 4 and FIG. 5 are diagrams of a principle structure of a hinge apparatus according to embodiments of this application, where FIG. 4 corresponds to an unfolded state of a foldable electronic device, and FIG. 5 corresponds to a folded state of the foldable electronic device.

As shown in FIG. 4 and FIG. 5, the hinge apparatus 100 includes a base 1, a first hinge assembly 21, and a second hinge assembly 22. The first hinge assembly 21 and the second hinge assembly 22 are respectively disposed on two sides of the base 1 in a first direction X and are rotatably connected to the base 1. Each hinge assembly rotates relative to the base 1, so that the first hinge assembly 21 and the second hinge assembly 22 rotate relative to each other.

Further, each of the first hinge assembly 21 and the second hinge assembly 22 includes a main swing arm 4, a movable plate 5, and a compensation mechanism 3. The movable plate 5 is slidably connected to the main swing arm 4, and the movable plate 5 is rotatably connected to the base 1 through the main swing arm 4. A rotation axis is a first axis Q1.

A manner in which the main swing arm 4 is rotatably connected to the base 1 is not limited. In an implementation, a main shaft 23 is disposed on the base 1, and the main swing arm 4 is rotatably connected to the base 1 through the main shaft 23, so that the main swing arm 4 rotates around the first axis Q1 relative to the base 1. The first axis Q1 extends in a second direction Y (a direction perpendicular to a paper surface in FIG. 4 and FIG. 5). The second direction Y is an extension direction of the main shaft 23 and is perpendicular to the first direction X. The second direction Y may be understood as a length direction of the base 1, or may be understood as a width direction of the foldable electronic device 300 in the unfolded state. In an implementation, the main swing arm 4 is fastened to the main shaft 23, and the main shaft 23 rotates around the first axis Q1 relative to the base 1, so that the main swing arm 4 rotates around the first axis Q1 relative to the base 1. In another alternative implementation, the main shaft 23 may alternatively be fixed relative to the base 1, and the main swing arm 4 rotates around the first axis Q1 relative to the main shaft 23. This is not limited in this application. When the main shaft 23 is fixed relative to the base 1, the main shaft 23 and the base 1 may be of a split structure, or may be of an integrated structure. This is not limited in this application.

As shown in FIG. 4 and FIG. 5, the compensation mechanism 3 includes a first connecting rod 31, a second connecting rod 32, and a third connecting rod 33. Each of the first connecting rod 31, the second connecting rod 32, and the third connecting rod 33 includes a concentric portion and a rotating portion that are spaced apart. Concentric portions of all the connecting rods are rotatably connected to each other, so that any two connecting rods rotate relative to each other around a second axis Q2. Alternatively, it may be understood as that all the connecting rods are concentrically connected, and the second axis Q2 is a concentric axis.

The first connecting rod 31 is rotatably connected to the base 1 through the rotating portion 312 of the first connecting rod 31, so that the concentric portions of all the connecting rods rotate around a third axis Q3 relative to the base 1. The second connecting rod 32 is rotatably connected to the base 1 through the rotating portion 322 of the second connecting rod 32, and the rotating portion 322 of the second connecting rod 32 is mounted on the main shaft 23 or the main swing arm 4, so that the rotating portion 322 of the second connecting rod 32 rotates around the first axis Q1 relative to the base 1 under driving of the main swing arm 4 and drives the concentric portions of all the connecting rods to rotate around the third axis Q3 relative to the base 1. The third connecting rod 33 is rotatably connected to the movable plate 5 through the rotating portion 332 of the third connecting rod 33, so that the movable plate 5 and the third connecting rod 33 rotate relative to each other around a fourth axis Q4. All the second axis Q2, the third axis Q3, and the fourth axis Q4 extend in the second direction Y.

Alternatively, it may be understood as that the rotating portion 322 of the second connecting rod 32 eccentrically rotates around the first axis Q1, and drives the concentric portion 321 of the second connecting rod 32 to rotate around the third axis Q3, to control displacement of the concentric axis (the second axis Q2), and finally, the movement is transferred to the rotating portion 332 of the third connecting rod 33 through the third connecting rod 33. The rotating portion 322 of the second connecting rod 32 may be mounted on the main shaft 23, or may be mounted on the main swing arm 4. This is not limited in this application. In an implementation, the rotating portion 322 of the second connecting rod 32 is mounted on the main shaft 23.

When the main swing arm 4 rotates relative to the base 1, the movable plate 5 slides relative to the main swing arm 4 under driving of the main swing arm 4 and the compensation mechanism 3, to generate displacement in a direction toward or away from the base 1. The movable plate 5 of the first hinge assembly 21 is fastened to the first housing 81 of the foldable electronic device 300, and the movable plate 5 of the second hinge assembly 22 is fastened to the second housing 82 of the foldable electronic device 300.

The hinge apparatus 100 provided in this embodiment of this application is configured to implement unfolding and folding of the foldable electronic device 300. The first housing 81 of the foldable electronic device 300 is mounted on the movable plate 5 of the first hinge assembly 21, and the second housing 82 is mounted on the movable plate 5 of the second hinge assembly 22. In a process of folding the foldable electronic device 300, the main swing arms 4 of the first hinge assembly 21 and the second hinge assembly 22 separately rotate relative to the base 1. In this way, the main swing arms 4 of the hinge assemblies rotate relative to each other, to drive the movable plates 5 of the hinge assemblies to rotate relative to each other, so that the first housing 81 and the second housing 82 of the foldable electronic device 300 rotate relative to each other.

The movable plate 5 is slidably connected to the main swing arm 4, and a compensation mechanism 3 is disposed in each hinge assembly. The compensation mechanism 3 includes a first connecting rod 31, a second connecting rod 32, and a third connecting rod 33. Concentric portions of the three connecting rods are concentrically connected, and the second axis Q2 is a concentric axis. When the foldable electronic device 300 is folded and unfolded, a movement track of the second axis Q2 is jointly controlled through rotation of the first connecting rod 31 relative to the base 1, and eccentric movement of the rotating portion 322 of the second connecting rod 32, so that the second axis Q2 rotates relative to the base 1 and drives the rotating portion 332 of the third connecting rod 33 to move, to drive the movable plate 5 to slide relative to the main swing arm 4. The movable plate 5 slides relative to the main swing arm 4 under driving of the main swing arm 4 and the compensation mechanism 3, to generate displacement in a direction toward or away from the base 1, so as to change a distance between the movable plate 5 and the base 1.

Further, the first housing 81 and the second housing 82 of the foldable electronic device 300 also generate displacement in the direction toward or away from the base 1 under driving of the movable plates 5, and an overall length of the foldable apparatus 200 including the first housing 81, the second housing 82, and the hinge apparatus 100 is also adjusted, to adapt to different forms of the display screen 9. For example, in an inward folding electronic device, when the foldable electronic device 300 is in the unfolded state, a distance between the movable plate 5 of each hinge assembly and the base 1 is short, and an overall length of the foldable apparatus 200 is short. When the foldable electronic device 300 is in the folded state, a distance between the movable plate 5 of each hinge assembly and the base 1 is long, and the overall length of the foldable apparatus 200 is long, to adapt to a length of the display screen 9, and avoid stretching or squeezing of the display screen 9.

The following systematically describes a movement relationship between components in the hinge apparatus 100 with reference to a specific scenario in which a user uses the foldable electronic device 300: When the foldable electronic device 300 is switched from the unfolded state to the folded state, the user moves the first housing 81 or the second housing 82 (or may move both the housings) of the foldable electronic device 100, and the moved housing transfers a force applied by the user to the movable plate 5 of the hinge assembly in which the moved housing is located. In this way, the force is transferred to the main swing arm 4 through the movable plate 5, and the main swing arm 4 rotates around the first axis Q1 relative to the base 1 through the main shaft 23. In this case, the housing, the movable plate 5, the main swing arm 4, and a part that is of the display screen 9 and that corresponds to the housing rotate synchronously relative to the base 1. In addition, the main swing arm 4 drives the rotating portion 322 of the second connecting rod 32 to rotate around the first axis Q1 relative to the base 1, and the first connecting rod 31 rotates around the third axis Q3 relative to the base 1 under driving of the second connecting rod 32. Under a joint action of the first connecting rod 31 and the second connecting rod 32, the concentric portions of all the connecting rods rotate around the third axis Q3 relative to the base 1 (that is, the second axis Q2 rotates around the third axis Q3). Further, the concentric portion 311 of the third connecting rod 33 also rotates around the third axis Q3 relative to the base 1, and transfers movement to the rotating portion 332 of the third connecting rod 33. The rotating portion 332 of the third connecting rod 33 moves in a direction away from the base 1. Therefore, the movable plate 5 slides relative to the main swing arm 4 under a joint action of the housing and the third connecting rod 33, and generates displacement in the direction away from the base 1. In addition, the movable plate 5 and the third connecting rod 33 rotate relative to each other around the fourth axis Q4. When the foldable electronic device 300 is switched from the folded state to the unfolded state, a movement path of each component is opposite to the foregoing path.

It can be learned that through the hinge apparatus 100 provided in this application, a length of the foldable apparatus 200 in the foldable electronic device 300 can be adjusted, to avoid squeezing or stretching of the display screen 9 in a process of folding and unfolding, and avoid damage on the display screen 9.

Further, the three connecting rods in the compensation mechanism 3 rotate around the second axis Q2 together, that is, share one concentric axis, so that the structure is stable, an assembly error is small, and movement track accuracy of each connecting rod is high. In addition, an overall structure of the compensation mechanism 3 is compact, the compensation mechanism 3 occupies small space and can be disposed below the display screen 9 (that is, disposed in mounting space between the display screen 9 and the base 1), and the compensation mechanism 3 does not need to be disposed on two sides of the base 1 in a length direction (namely, the second direction Y) of the base 1 to avoid the display screen 9, thereby facilitating a narrow-bezel design of the foldable electronic device and maximizing the display screen.

It should be noted that FIG. 4 and FIG. 5 are merely diagrams of a principle of the hinge apparatus 100, and do not represent an actual structure of the hinge apparatus 100. A specific structure of each component in the hinge apparatus 100 is not limited in this application. A possible structure of the hinge apparatus 100 is described below by using an example with reference to the accompanying drawings.

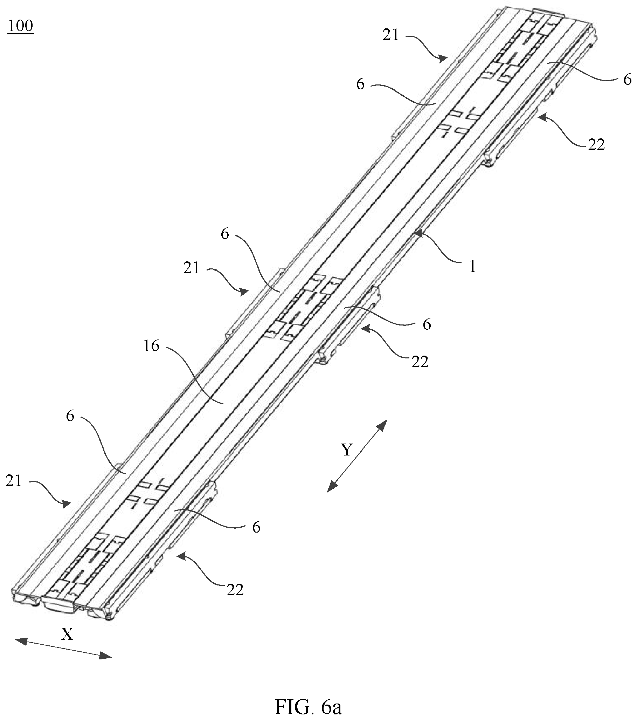

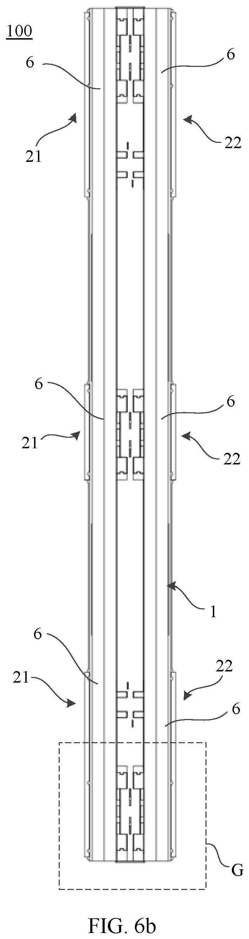

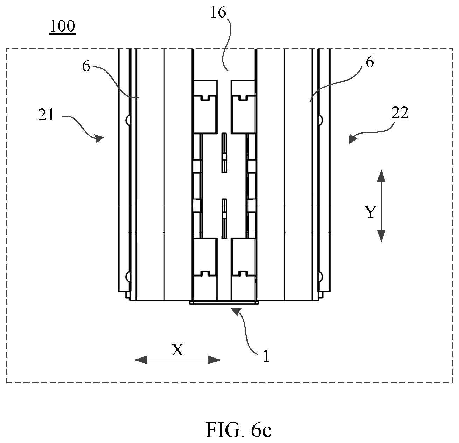

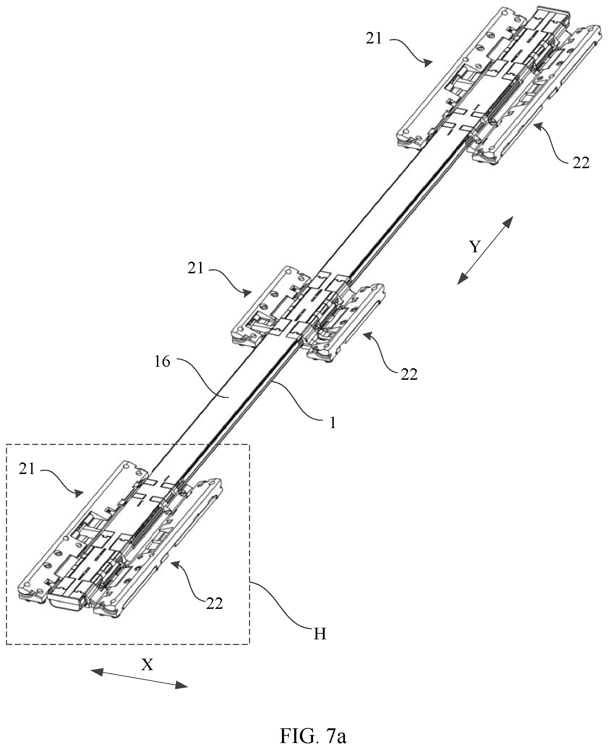

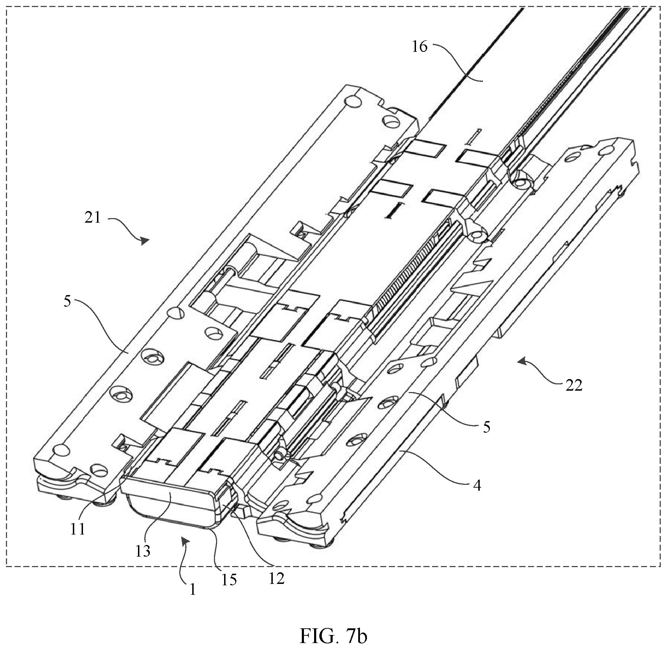

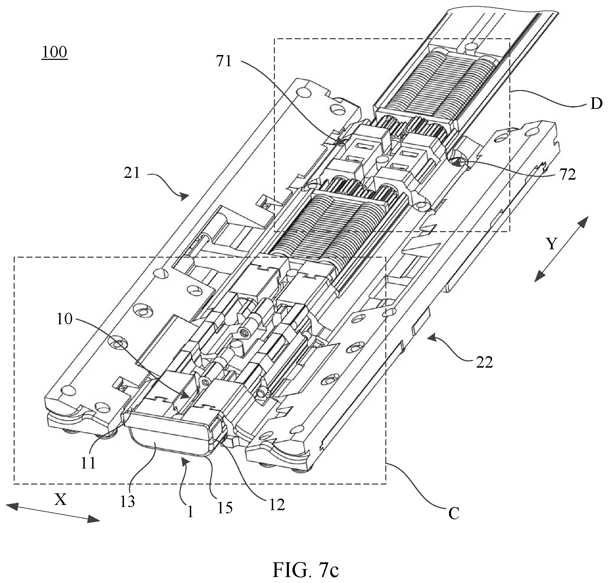

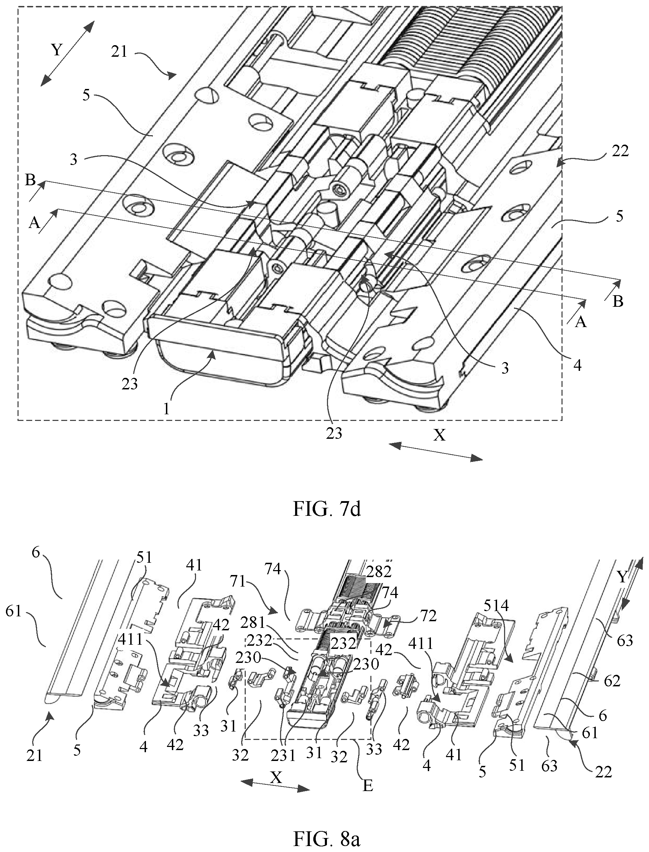

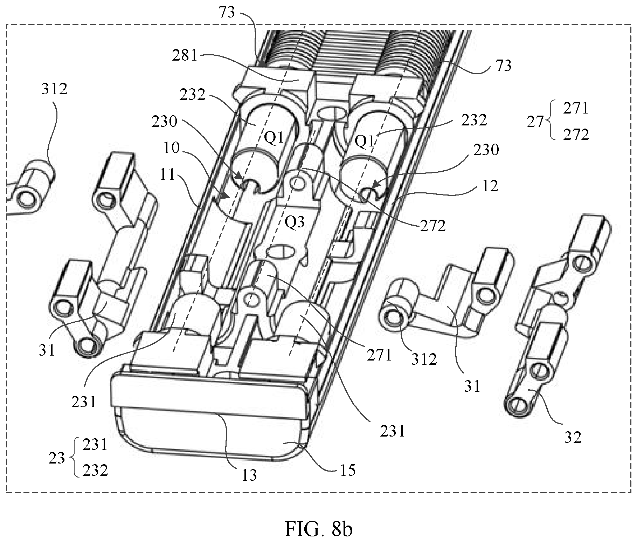

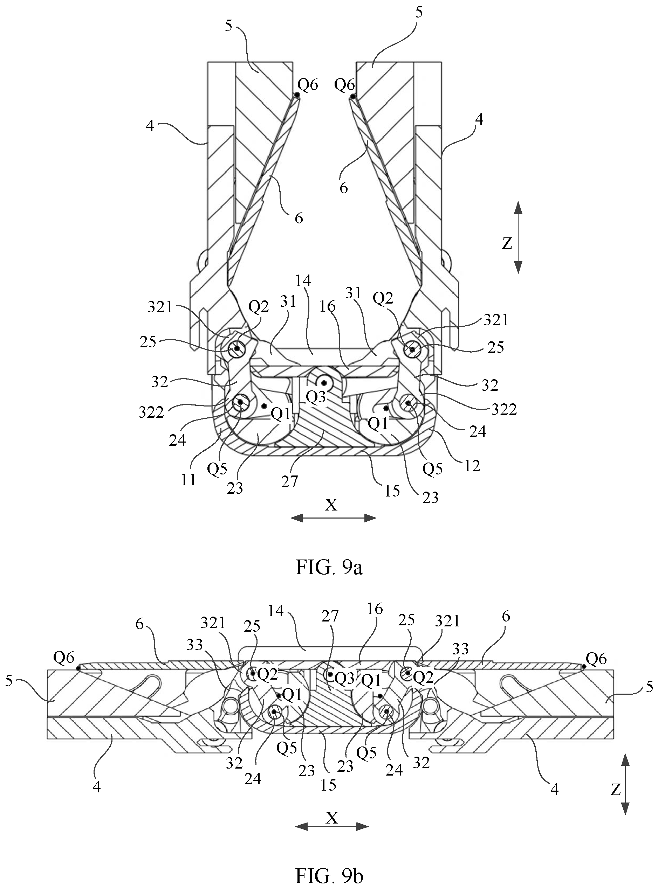

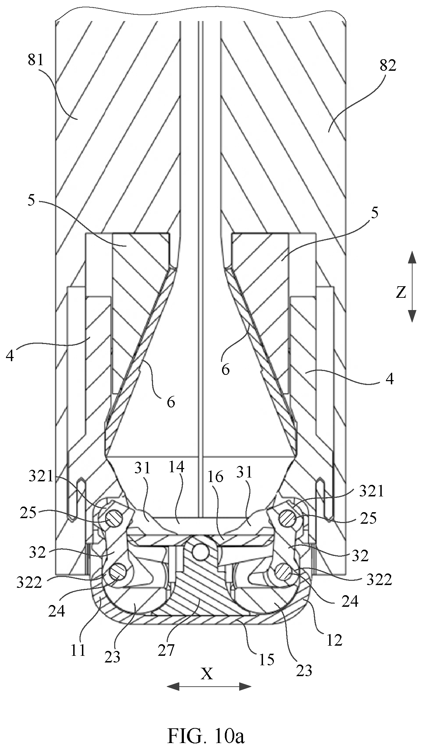

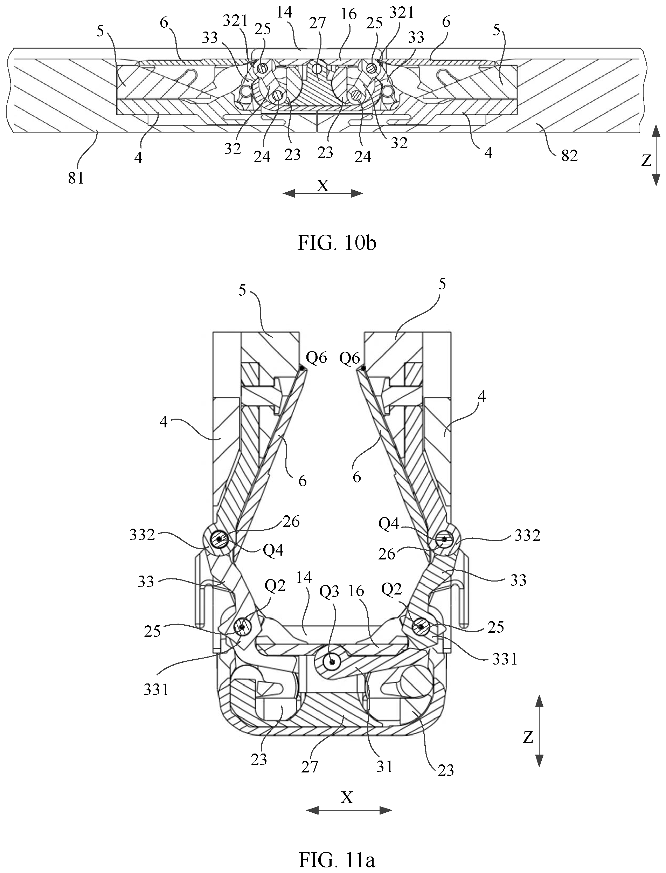

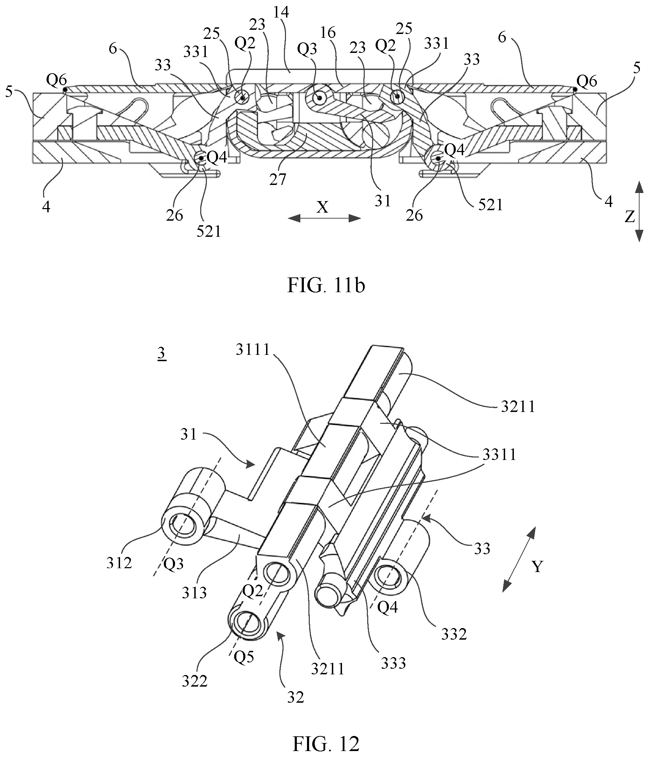

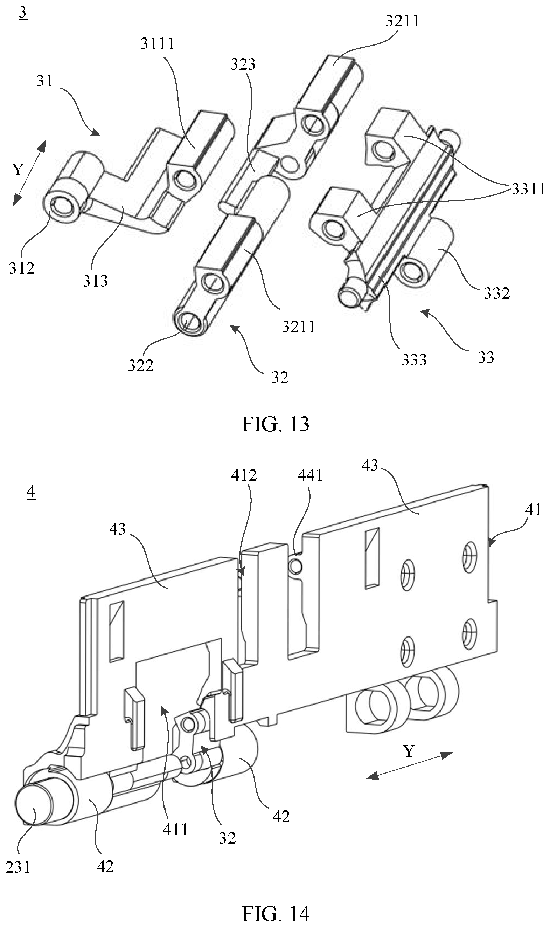

FIG. 6a is a diagram of a three-dimensional structure of a hinge apparatus according to an embodiment of this application. FIG. 6b is a schematic top view of a structure of a hinge apparatus according to an embodiment of this application. FIG. 6c is a partially enlarged view of a part G in FIG. 6b. FIG. 7a is a diagram of a structure of a hinge apparatus in which a support plate is removed according to an embodiment of this application. FIG. 7b is a partially enlarged view of a part H in FIG. 7a. FIG. 7c is a diagram of a structure in which a cover plate is removed in FIG. 7b. FIG. 7d is a partially enlarged view of a part C in FIG. 7c. FIG. 8a is an exploded view of a structure of a hinge apparatus according to an embodiment of this application. FIG. 8b is a partially enlarged view of a part E in FIG. 8a. FIG. 9a and FIG. 9b are cross-sectional views in an A-A direction in FIG. 7d, where FIG. 9a corresponds to a folded state of a foldable electronic device, and FIG. 9b corresponds to an unfolded state of the foldable electronic device. FIG. 10a and FIG. 10b are schematic cross-sectional views of a structure of a foldable apparatus according to an embodiment of this application, where FIG. 10a corresponds to a folded state of a foldable electronic device, FIG. 10b corresponds to an unfolded state of the foldable electronic device, and cross-sectional locations in FIG. 10a and FIG. 10b are consistent with those in FIG. 9a and FIG. 9b. FIG. 11a and FIG. 11b are cross-sectional views in a B-B direction in FIG. 7d, where FIG. 11a corresponds to a folded state of a foldable electronic device, and FIG. 11b corresponds to an unfolded state of the foldable electronic device. FIG. 12 is a diagram of a structure of a compensation mechanism in a hinge apparatus according to an embodiment of this application. FIG. 13 is an exploded view of a structure of a compensation mechanism in a hinge apparatus according to an embodiment of this application. In addition, in FIG. 9a and FIG. 9b, and FIG. 11a and FIG. 11b, a support plate 6 is further added. A function of the support plate 6 is described in the following.

A person skilled in the art may understand that, a quantity of first hinge assemblies 21 and a quantity of second hinge assemblies 22 are not limited, and may be 1, 2, 3, or more. The quantity of first hinge assemblies 21 may be equal to or may be different from the quantity of second hinge assemblies 22. As shown in FIG. 6a to FIG. 7a, in an implementation, the hinge apparatus 100 includes three first hinge assemblies 21 and three second hinge assemblies 22 that are spaced apart in the second direction Y. The three first hinge assemblies 21 are in one-to-one correspondence with the three second hinge assemblies 22. A plurality of hinge assemblies are disposed, so that a force applied to the foldable electronic device 300 is more even in a process of folding and unfolding, and a rotating feeling is consistent at each place.

A person skilled in the art may understand that a specific structure of the base 1 is not limited. As shown in FIG. 6a to FIG. 11b, in an implementation, the base 1 includes a bottom plate 15, a first side wall 11 and a second side wall 12 that are disposed opposite to each other in the first direction X, and a third side wall 13 and a fourth side wall 14 that are disposed opposite to each other in the second direction Y. The bottom plate 15, the first side wall 11, the second side wall 12, the third side wall 13, and the fourth side wall 14 enclose an accommodating groove 10, the main shaft 23 of each hinge assembly is disposed in the accommodating groove 10, and a part of the compensation mechanism 3 is located in the accommodating groove 10. Alternatively, it may be understood as that the entire base 1 is disposed as a groove-shaped structure. The main shaft 23 is accommodated in the base 1, a part of the compensation mechanism 3 is located in the base 1, and a part of the compensation mechanism 3 extends out of the base 1 and is connected to components such as the main swing arm 4 and the movable plate 5.

A person skilled in the art may understand that a location relationship between the first axis Q1 and the third axis Q3 in the compensation mechanism 3 of each hinge assembly is not limited. In an implementation, the third axis Q3 is located, in the first direction X, on a side that is of the first axis Q1 and that is close to another hinge assembly. Alternatively, it may be understood as that the third axis Q3 of each hinge assembly is located between the main shafts 23 of two hinge assemblies in the first direction X. Through this structure, the third axis Q3 of the first hinge assembly 21 and the third axis Q3 of the second hinge assembly 22 may coincide and may be shared, thereby saving space.

As shown in FIG. 8b to FIG. 11b, in an implementation, the hinge apparatus 100 further includes a fastened bracket 27. The fastened bracket 27 is disposed on the base 1. The rotating portion 312 of the first connecting rod 31 in each hinge assembly is rotatably connected to the fastened bracket 27, so that the first connecting rod 31 in each hinge assembly is rotatably connected to the base 1, and the third axes Q3 of all the hinge assemblies coincide. Alternatively, it may be understood as that the first hinge assembly 21 and the second hinge assembly 22 share one third axis Q3. This design is compact, and space occupied by the hinge apparatus 100 in the first direction X is reduced. It should be noted that the fastened bracket 27 may be a component fastened on the base 1 (that is, the fastened bracket 27 and the base 1 are of a split structure), or may be disposed as an integrated structure with the base 1. This is not limited in this application.

It should be noted that a specific structure of the fastened bracket 27 and a specific connection manner between each first connecting rod 31 and the fastened bracket 27 are not limited. In an implementation, the fastened bracket 27 includes a first bracket 271 and a second bracket 272 that are spaced apart in the second direction Y. The rotating portion 312 of the first connecting rod 31 in each hinge assembly is disposed between the first bracket 271 and the second bracket 272. In addition, the rotating portion 312 of the first connecting rod 31 in the first hinge assembly 21 is rotatably connected to the first bracket 271, and the rotating portion 322 of the second connecting rod 32 in the second hinge assembly 22 is rotatably connected to the second bracket 272. The hinge apparatus 100 further includes a fastened shaft (not shown in the figure). All the first bracket 271, the second bracket 272, and the rotating portion 312 of the first connecting rod 31 in each hinge assembly are disposed as sleeve structures and are coaxially disposed in the second direction Y. The fastened shaft sequentially penetrates the first bracket 271, the rotating portion 312 of the first connecting rod 31 in the first hinge assembly 21, the rotating portion 312 of the first connecting rod 31 in the second hinge assembly 22, and the second bracket 272, so that the first connecting rod 31 in each hinge assembly is rotatably connected to the base 1. In another alternative implementation, only one bracket may alternatively be disposed in the fastened bracket 27, and the first connecting rod 31 in each hinge assembly may be connected to the same bracket. This is not limited in this application.

A person skilled in the art may understand that a structure of each connecting rod in the compensation mechanism 3 is not limited, and a connection manner between each connecting rod and another component is not limited.

As shown in FIG. 9a to FIG. 11b, in an implementation, the rotating portion 322 of the second connecting rod 32 is mounted on an eccentric shaft 24 and is mounted on the main shaft 23 through the eccentric shaft 24. When rotating, the main swing arm 4 drives the main shaft 23 and the eccentric shaft 24 on the main shaft 23 to rotate, so as to drive the rotating portion 322 of the second connecting rod 32 to rotate. Alternatively, it may be understood as that, in a process in which the main swing arm 4 rotates relative to the base 1, the main swing arm 4 and the main shaft 23 are fixed relative to each other, and the main shaft 23 rotates around the first axis Q1 relative to the base 1, to drive the eccentric shaft 24 to rotate around the first axis Q1. Because the rotating portion 322 of the second connecting rod 32 is mounted on the eccentric shaft 24, the rotating portion 322 of the second connecting rod 32 also rotates around the first axis Q1 under driving of the eccentric shaft 24.

In an implementation, the eccentric shaft 24 of each hinge assembly penetrates the main shaft 23. The rotating portion 322 of the second connecting rod 32 is disposed as a sleeve structure and is sleeved on an outer circumference of the eccentric shaft 24. When the rotating portion 322 of the second connecting rod 32 rotates around the first axis Q1 relative to the base 1 under driving of the main swing arm 4, the second connecting rod 32 rotates around a fifth axis Q5 relative to the main shaft 23. The fifth axis Q5 is an axis of the eccentric shaft 24 and is parallel to the first axis Q1. Through this structure, the eccentric shaft 24 and the main shaft 23 have high connection strength and high stability, and movement track accuracy of the rotating portion 322 of the second connecting rod 32 is high.

A person skilled in the art may understand that a specific connection manner between the eccentric shaft 24 and the main shaft 23 is not limited. As shown in FIG. 8b, in an implementation, a shaft hole 230 is provided on the main shaft 23. The shaft hole 230 and an axis of the main shaft 23 are spaced apart in a radial direction of the main shaft 23. The eccentric shaft 24 passes through the shaft hole 230. In the radial direction of the main shaft 23, the entire eccentric shaft 24 may be located in the main shaft 23, or only a partial structure may be located in the main shaft 23. This is not limited in this application. In an implementation, the shaft hole 230 is provided on an outer wall surface of the main shaft 23, and a notch is formed on the outer wall surface of the main shaft 23. A partial structure of the eccentric shaft 24 is embedded in the main shaft 23 in the radial direction of the main shaft 23. The notch is provided on the outer wall surface of the main shaft 23 to facilitate mounting of the eccentric shaft 24 on the main shaft 23.

A person skilled in the art may understand that a structure of the concentric portion of each connecting rod is not limited. As shown in FIG. 12 and FIG. 13, it is understood with reference to FIG. 6a to FIG. 11b that, in an implementation, the concentric portion 311 of the first connecting rod 31 includes a first connecting portion 3111, the concentric portion 321 of the second connecting rod 32 includes two second connecting portions 3211 spaced apart in the second direction Y, and the concentric portion 331 of the third connecting rod 33 includes two third connecting portions 3311 spaced apart in the second direction Y. In the second direction Y, the two third connecting portions 3311 of the third connecting rod 33 are disposed between the two second connecting portions 3211 of the second connecting rod 32, and the first connecting portion 3111 of the first connecting rod 31 is disposed between the two third connecting portions 3311 of the third connecting rod 33. Alternatively, it may be understood as that the concentric portions of all the connecting rods are nested in the second direction Y, and a structure is compact.

It should be noted that a manner in which the concentric portions of all the connecting rods rotate and are connected to each other is not limited. In an implementation, the compensation mechanism 3 further includes a concentric shaft 25. Each of the first connecting portion 3111, the two second connecting portions 3211, and the two third connecting portions 3311 is disposed as a sleeve structure, all the connecting portions are coaxially disposed in the second direction Y, and the concentric shaft 25 penetrates all the connecting portions, so that any two connecting rods rotate relative to each other around the second axis Q2. A quantity of concentric shafts 25 is not limited, and may be one or two. For example, only one concentric shaft 25 may be disposed, and one concentric shaft 25 penetrates all the connecting portions of all the connecting rods. Alternatively, two concentric shafts 25 may be disposed in the second direction Y. The first connecting portion 3111, one second connecting portion 3211, and one third connecting portion 3311 are rotatably connected through one concentric shaft 25, and the first connecting portion 3111, the other second connecting portion 3211, and the other third connecting portion 3311 are rotatably connected through the other concentric shaft 25. All the connecting rods are connected through the concentric shaft 25, so that the structure is stable and an assembly error is small. In another alternative implementation, the concentric shaft 25 may not be disposed. For example, the connecting portions of all the connecting rods may be hinged to each other to implement a rotatable connection.

As shown in FIG. 12 and FIG. 13, in an implementation, the rotating portion 312 of the first connecting rod 31 is connected to the first connecting portion 3111 through a first connecting plate, 313 the rotating portion 322 of the second connecting rod 32 is connected to the two second connecting portions 3211 through a second connecting plate 323, and the rotating portion 332 of the third connecting rod 33 is connected to the two third connecting portions 3311 through a third connecting plate 333. The first connecting plate 313, the second connecting plate 323, and the third connecting plate 333 each are disposed as a plate structure. The plate structure is stable, is not easy to deform, and has high reliability. In addition, a connecting rod of a plate structure may be processed into a bent shape based on a shape and a location of each component in an actual product, to avoid another structural member, for example, avoid an appearance member (a cover plate 16 in FIG. 9a and FIG. 9b) on the base 1. This reduces openings on the appearance member, so that a product has a complete appearance. In another alternative implementation, the rotating portions and the connecting portions of all the connecting rods may alternatively be connected through a rod structure, a sheet structure, or the like. This is not limited in this application.

It should be noted that the rotating portions and the connecting portions of all the connecting rods, and the connecting plates may be integrally formed, or may be of a split structure. In an implementation, the rotating portion of the first connecting rod 31, the first connecting portion 3111, and the first connecting plate 313 are disposed as an integrated structure. The rotating portion of the second connecting rod 32, the two second connecting portions 3211, and the second connecting plate 323 are disposed as an integrated structure. The rotating portion of the third connecting rod 33, the two third connecting portions 3311, and the third connecting plate 333 are disposed as an integrated structure. All the connecting rods are integrally formed and are more secure. This simplifies production and mounting processes.

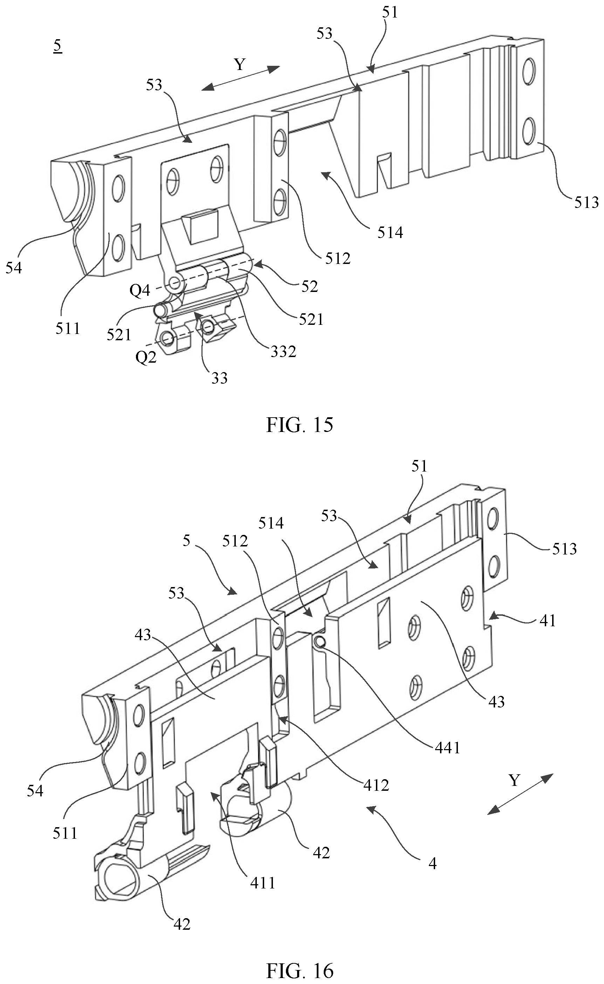

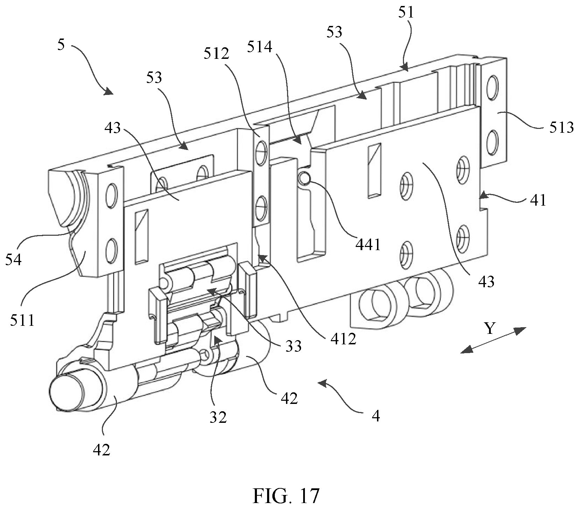

FIG. 14 is a diagram of a structure of a main swing arm in a hinge apparatus according to an embodiment of this application. FIG. 15 is a diagram of an assembly structure of a movable plate and a third connecting rod in a hinge apparatus according to an embodiment of this application. FIG. 16 is a diagram of an assembly structure of a main swing arm and a movable plate in a hinge apparatus according to an embodiment of this application. FIG. 17 is a diagram of an assembly structure of a main swing arm and a movable plate with a connecting rod in a hinge apparatus according to an embodiment of this application.

A person skilled in the art may understand that specific structures of the main swing arm 4 and the movable plate 5 are not limited. As shown in FIG. 14 to FIG. 17, in an implementation, the main swing arm 4 includes a main body portion 41 and two connecting arms 42 connected to the main body portion 41. The two connecting arms 42 are fastened to the main shaft 23, and the main shaft 23 rotates around the first axis Q1 relative to the base 1 under driving of the main swing arm 4, so that the main swing arm 4 rotates around the first axis Q1 relative to the base 1.

A specific structure of the main shaft 23 and a connection manner between the connecting arm 42 and the main shaft 23 are not limited. In an implementation, the main shaft 23 includes a first shaft body 231 and a second shaft body 232 that are spaced apart in the second direction Y. Each of the two connecting arms 42 of the main swing arm 4 is disposed as a sleeve structure. One of the two connecting arms 42 is sleeved and fastened on the first shaft body 231, and the other of the two connecting arms 42 is sleeved and fastened on the second shaft body 232, so that the first shaft body 231 and the second shaft body 232 of the main shaft 23 rotate synchronously under driving of the main swing arm 4. A first hollow portion 411 is disposed on the main body portion 41 of the main swing arm 4, and the first hollow portion 411 is located between the two connecting arms 42 in the second direction Y and is in communication with space between the two connecting arms 42, so that the two connecting arms 42 and the main body portion 41 enclose accommodating space, and the entire compensation mechanism 3 is located in the accommodating space. Alternatively, it may be understood as that the main shaft 23 is divided into two parts and the first hollow portion 411 is disposed on the main swing arm 4 to avoid a structure of the compensation mechanism 3, and the compensation mechanism 3 is accommodated in a cavity between the main shaft 23 and the main swing arm 4, so that the overall structure of the hinge apparatus 100 is more compact, to save space.

In an implementation, the movable plate 5 includes a body portion 51. The main body portion 41 of the main swing arm 4 and the body portion 51 of the movable plate 5 are stacked and are slidably connected through a sliding structure. A quantity of sliding structures is not limited, and may be 1, 2, 3, or the like. Each sliding structure in the sliding structure includes a slide rail 53 and a sliding block 43 that are slidably connected to each other. One of the slide rail 53 and the sliding block 43 is disposed on the body portion 51 of the movable plate 5, and the other of the slide rail 53 and the sliding block 43 is disposed on the main body portion 41 of the main swing arm 4. This is not limited in this application.

In an implementation, a first bump 511, a second bump 512, and a third bump 513 that are sequentially spaced apart in the second direction Y are disposed on the body portion 51 of the movable plate 5, and each of the first bump 511, the second bump 512, and the third bump 513 protrudes from the body portion 51 toward a side close to the main swing arm 4. The entire main body portion 41 of the main swing arm 4 is located between the first bump 511 and the third bump 513 in the second direction Y. In addition, a groove 412 corresponding to the second bump 512 is provided on the main body portion 41, and the second bump 512 is embedded in the groove 412 and slides in the groove 412. In the second direction Y, one slide rail 53 is formed between the first bump 511 and the second bump 512, one slide rail 53 is formed between the second bump 512 and the third bump 513, parts that are of the main body portion 41 of the main swing arm 4 and that are located on two sides of the groove 412 each form one sliding block 43, and each sliding block 43 is in one-to-one correspondence with each slide rail 53. Alternatively, it may be understood as that the main body portion 41 of the main swing arm 4 is slidably connected to the body portion 51 of the movable plate 5 through two sliding structures. The main body portion 41 of the main swing arm 4 is divided into two parts through the groove 412. Each part forms one sliding block 43, and each sliding block 43 slides between two bumps of the movable plate 5. The main body portion 41 is designed as a sliding block 43. The structure is simple, and an area of sliding connection between the main swing arm 4 and the movable plate 5 is large.

As shown in FIG. 15, in an implementation, the movable plate 5 further includes a rotatable connecting member 52 connected to the body portion 51. The rotatable connecting member 52 is rotatably connected to the rotating portion 332 of the third connecting rod 33, so that the third connecting rod 33 is rotatably connected to the movable plate 5. The rotatable connecting member 52 and the body portion 51 of the movable plate 5 may be of a split structure, or may be of an integrated structure. This is not limited in this application. A specific structure of the rotatable connecting member 52 is not limited. In an implementation, the rotatable connecting member 52 of the movable plate 5 includes two rotating arms 521 spaced apart in the second direction Y. The rotating portion 332 of the third connecting rod 33 is disposed between the two rotating arms 521. All the rotating portion 332 of the third connecting rod 33 and the two connecting arms 42 of the movable plate 5 are disposed as sleeve structures, and are coaxially disposed in the second direction Y. The compensation mechanism 3 further includes a rotatable connecting shaft 26. The rotatable connecting shaft 26 penetrates the rotating portion 332 of the third connecting rod 33 and the two connecting arms 42 of the movable plate 5, so that the third connecting rod 33 is rotatably connected to the movable plate 5. In another alternative implementation, the rotatable connecting shaft 26 may not be disposed. For example, the rotating portion of the third connecting rod 33 may be hinged to the two connecting arms 42 of the movable plate 5, to implement relative rotation between the third connecting rod 33 and the movable plate 5. This is not limited in this application.

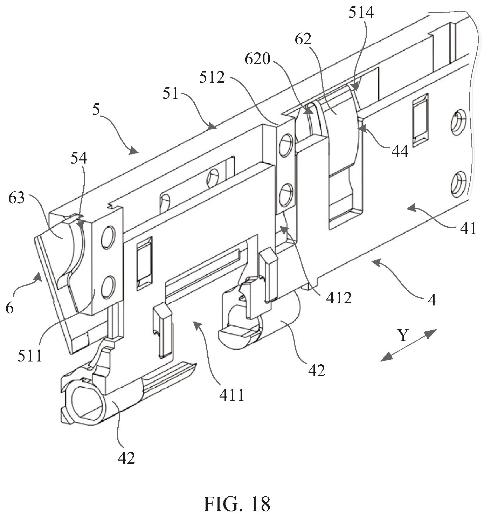

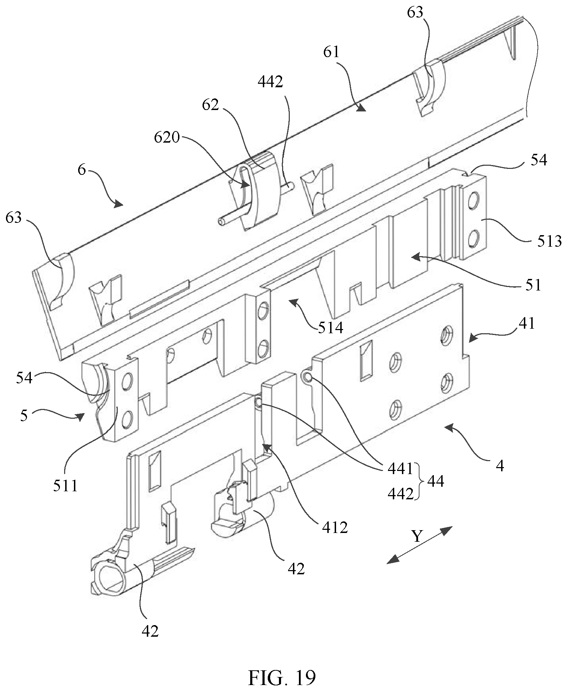

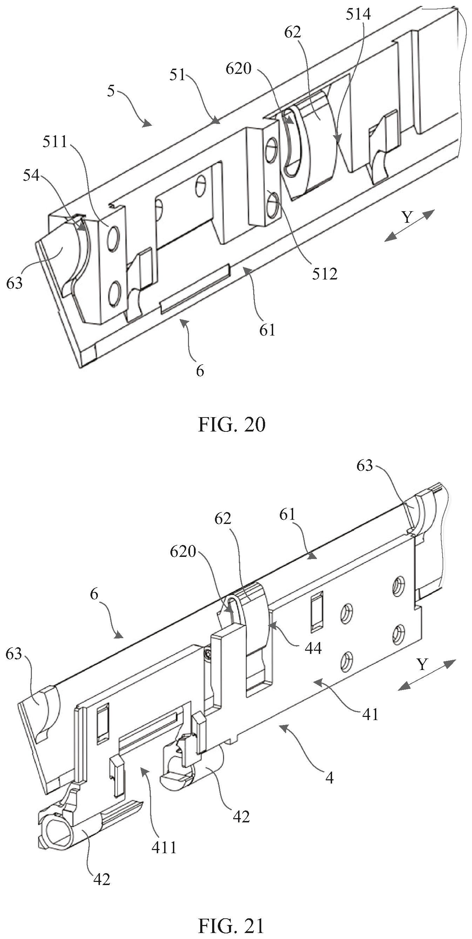

FIG. 18 is a diagram of an assembly structure of a main swing arm, a movable plate, and a support plate in a hinge apparatus according to an embodiment of this application. FIG. 19 is an exploded view of a structure of a main swing arm, a movable plate, and a support plate in a hinge apparatus according to an embodiment of this application. FIG. 20 is a diagram of an assembly structure of a support plate and a movable plate in a hinge apparatus according to an embodiment of this application. FIG. 21 is a diagram of an assembly structure of a support plate and a main swing arm in a hinge apparatus according to an embodiment of this application.

As shown in FIG. 18 to FIG. 21, in an implementation, each hinge assembly further includes a support plate 6. The support plate 6 is configured to support the display screen 9 of the foldable electronic device 300 and is stacked on a side that is of the movable plate 5 and that faces away from the main swing arm 4. The support plate 6 is separately slidably connected to the movable plate 5 and the main swing arm 4. When the main swing arm 4 rotates around the first axis Q1 relative to the base 1, the support plate 6 slides relative to the main swing arm 4 under driving of the movable plate 5 and slides relative to the movable plate 5 along an arc-shaped track, so that the support plate 6 rotates around a sixth axis Q6 relative to the movable plate 5. The sixth axis Q6 extends in the second direction Y. Alternatively, it may be understood as that in a rotation process of the main swing arm 4, in addition to sliding relative to the main swing arm 4 along with the movable plate 5, the support plate 6 further rotates relative to the movable plate 5, so that different angles are presented between the support plate 6 and the movable plate 5, to support the display screen 9 in different states.

For example, as shown in FIG. 9b, FIG. 10b, and FIG. 11b, when the foldable electronic device 300 is in the unfolded state, the support plate 6 of each hinge assembly is opened relative to the movable plate 5 and is attached to the display screen 9 in the unfolded state. As shown in FIG. 9a, FIG. 10a, and FIG. 11a, when the foldable electronic device 300 is in the folded state, the support plate 6 of each hinge assembly rotates to fit the movable plate 5, to avoid the foldable part 93 of the display screen 9, and guide the foldable part 93 to bend in a water drop shape.

As shown in FIG. 6a and FIG. 6b, in an implementation, to simplify production and processing procedures, support plates 6 of the three first hinge assemblies 21 in the hinge apparatus 100 are disposed as an integrated structure, and support plates 6 of the three second hinge assemblies 22 are disposed as an integrated structure. In another alternative implementation, the support plates 6 of the first hinge assemblies 21 may be separately disposed, and the support plates 6 of the second hinge assemblies 22 may be separately disposed. This is not limited in this application.

As shown in FIG. 6a to FIG. 7b and FIG. 9a to FIG. 11b, in an implementation, the base 1 further includes a cover plate 16. The cover plate 16 is disposed opposite to the bottom plate 15 in a third direction Z and is configured to support the display screen 9 of the foldable electronic device 300. The cover plate 16 is configured to support the foldable part 93 of the display screen 9. For example, when the foldable electronic device 300 is in the unfolded state, the support plate 6 of each hinge assembly is connected to the cover plate 16 of the base 1 to form a flat plate structure, to jointly support all parts of the display screen 9. The third direction Z is perpendicular to the first direction X and the second direction Y. It should be noted that the third direction Z may be understood as a thickness direction of the base 1, or may be understood as a thickness direction of the foldable electronic device 300 in the unfolded state.

A person skilled in the art may understand that a specific structure of the support plate 6 is not limited. As shown in FIG. 18 to FIG. 21, in an implementation, the support plate 6 includes a plate body 61, a first boss 62, and two second bosses 63 respectively located on two sides of the first boss 62 in the second direction Y. Each of the first boss 62 and the two second bosses 63 is connected to the plate body 61 and protrudes from the plate body 61 toward a side close to the main swing arm 4. The entire movable plate 5 is located between the two second bosses 63 of the support plate 6 in the second direction Y, arc-shaped slide rails 54 are disposed at two ends of the movable plate 5, and each of the two second bosses 63 is disposed as an arc-shaped structure and slides in a corresponding arc-shaped slide rail 54, so that the support plate 6 slides relative to the movable plate 5 along the arc-shaped track.

In an implementation, the main swing arm 4 includes a connecting boss 44 protruding from the main body portion 41 toward a side close to the support plate 6. A second hollow portion 514 is disposed on the body portion 51 of the movable plate 5, and both the connecting boss 44 of the main swing arm 4 and the first boss 62 of the support plate 6 are accommodated in the second hollow portion 514 of the movable plate 5 and are slidably connected to each other, so that the support plate 6 is slidably connected to the movable plate 5. Alternatively, it may be understood as that the movable plate 5 is stacked between the main swing arm 4 and the support plate 6. To avoid a connecting member between the main swing arm 4 and the support plate 6, a corresponding location on the movable plate 5 is hollowed out.

Specific structures of the first boss 62 and the connecting boss 44 are not limited. In an implementation, an arc-shaped hole 620 is provided on the first boss 62 of the support plate 6, and the arc-shaped hole 620 extends through the first boss 62 in the second direction Y and extends along an arc line in a plane perpendicular to the second direction Y. The connecting boss 44 of the main swing arm 4 includes two connecting brackets 441 spaced apart in the second direction Y, and the first boss 62 is located between the two connecting brackets 441. The connecting boss 44 of the main swing arm 4 further includes a sliding rod 442. Two ends of the sliding rod 442 are mounted on the two connecting brackets 441, the sliding rod 442 passes through the arc-shaped hole 620 of the first boss 62, and the sliding rod 442 slides in the arc-shaped hole 620, so that the support plate 6 slides relative to the main swing arm 4 along an arc-shaped track. In another alternative implementation, the support plate 6 may alternatively be slidably connected to the main swing arm 4 through a structure such as a sliding block and a sliding groove. This is not limited in this application.

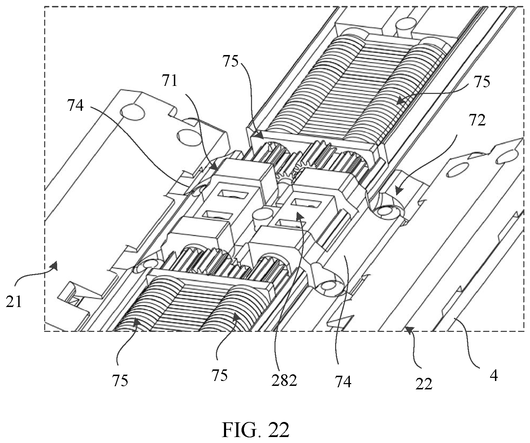

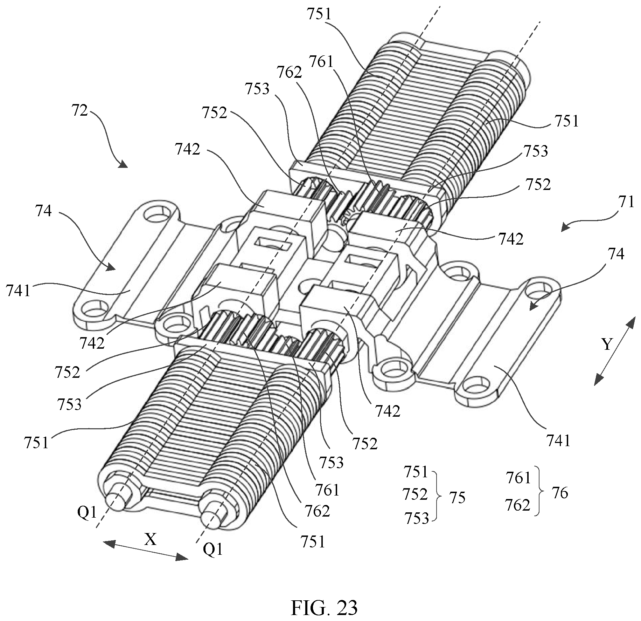

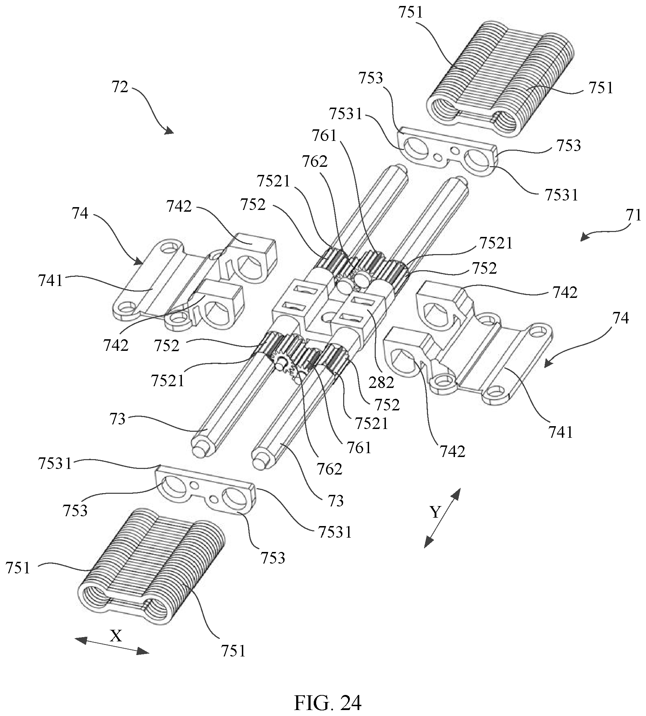

FIG. 22 is a partially enlarged view of a part D in FIG. 7c. FIG. 23 is a diagram of a three-dimensional structure of a damping structure in a hinge apparatus according to an embodiment of this application. FIG. 24 is an exploded view of a structure of a damping structure in a hinge apparatus according to an embodiment of this application.

As shown in FIG. 22 to FIG. 24, in an implementation, the hinge apparatus 100 further includes a damping structure. The damping structure may generate a damping force, so that the foldable electronic device 300 can hover at a specific angle in a process of unfolding or folding.

Specifically, the damping structure includes a first damping structure 71 and a second damping structure 72. The first damping structure 71 and the second damping structure 72 are respectively disposed on two sides of the base 1 in the first direction X. A specific quantity of first damping structures 71 and a specific quantity of second damping structures 72 are not limited, and each may be one, two, or more. The quantity of first damping structures 71 may be the same as or different from the quantity of second damping structures 72. This is not limited in this application.

Each damping structure includes a damping shaft 73 and a damping swing arm 74. The damping shaft 73 is rotatably connected to the base 1, and the damping swing arm 74 is fastened to the damping shaft 73, so that the damping swing arm 74 is rotatably connected to the base l through the damping shaft 73. The damping swing arm 74 of the first damping structure 71 is fastened to the main swing arm 4 of the first hinge assembly 21, so that the damping swing arm 74 of the first damping structure 71 rotates around the first axis Q1 of the first hinge assembly 21 relative to the base 1 under driving of the main swing arm 4. The damping swing arm 74 of the second damping structure 72 is fastened to the main swing arm 4 of the second hinge assembly 22, so that the damping swing arm 74 of the second damping structure 72 rotates around the first axis Q1 of the second hinge assembly 22 relative to the base 1 under driving of the main swing arm 4. When a user rotates any part of the foldable electronic device 300, the main swing arm 4 rotates to drive a corresponding damping swing arm 74 to rotate, to transfer the damping force to the user through the damping swing arm 74. A specific structure of the damping swing arm 74 is not limited. In an implementation, the damping swing arm 74 includes a fastening plate 741 and two rotation arms 742 connected to the fastening plate 741. The fastening plate 741 is fastened to a corresponding main swing arm 4. The two rotation arms 742 are spaced apart in the second direction Y, and both are sleeved on the damping shaft 73.

Further, each damping structure further includes a damping module 75. The damping module 75 is a core component that generates the damping force, and a specific quantity of damping modules 75 is not limited. Each damping structure may include one or more damping modules 75. In an implementation, each damping structure includes two damping modules 75. The two damping modules 75 are respectively disposed on two sides of the damping swing arm 74 in the second direction Y.

It should be noted that a specific structure of the damping module 75 is not limited. In an implementation, each damping module 75 includes an elastic member 751, a first gear 752, and a shaft sleeve 753 that separately penetrate the damping shaft 73. The shaft sleeve 753 is disposed between the elastic member 751 and the first gear 752 in the second direction Y, and the shaft sleeve 753 is sleeved on the damping shaft 73. The first gear 752 is disposed on the damping shaft 73 and is fixed relative to the damping shaft 73, so that the first gear 752 rotates relative to the base 1 and rotates relative to the shaft sleeve 753 under driving of the damping shaft 73. The first gear 752 includes a first end surface 7521 facing the shaft sleeve 753. The shaft sleeve 753 includes a second end surface 7531 facing the first gear 752. The elastic member 751 applies an elastic force to the shaft sleeve 753 and the first gear 752 through deformation of the elastic member 751, so that the first end surface 7521 and the second end surface 7531 are mutually squeezed. Alternatively, it may be understood as that the shaft sleeve 753 matches the first gear 752 through the end surfaces. In a process of folding and unfolding the foldable electronic device 300, the end surfaces of the shaft sleeve 753 and the first gear 752 rotate relative to each other, and are mutually squeezed under a squeezing force of the elastic member 751, to generate a friction force, where the friction force is the damping force. Some uneven structures may be disposed on the first end surface 7521 and the second end surface 7531, so that the friction force between the first end surface 7521 and the second end surface 7531 changes as an angle at which the foldable electronic device 300 is opened or folded changes. This is not limited in this application. The elastic member 751 may be a spring or the like. This is not limited in this application.

A person skilled in the art may understand that the friction force can be generated only when the shaft sleeve 753 and the first gear 752 in the damping module 75 rotate relative to each other. Therefore, the first gear 752 rotates relative to the damping shaft 73, and rotates along with the damping shaft 73 under driving of the damping swing arm 74, and the shaft sleeve 753 rotates relative to the damping shaft 73, so that the shaft sleeve 753 can rotate relative to the first gear 752. In an implementation, the shaft sleeves 753 in the first damping structure 71 and the second damping structure 72 are correspondingly disposed in the first direction X, and two corresponding shaft sleeves 753 are disposed as an integrated structure, so that each shaft sleeve 753 may rotate relative to a respective damping shaft 73. In another alternative implementation, the first gear 752 may alternatively rotate relative to the damping shaft 73, and the shaft sleeve 753 is fixed relative to the damping shaft 73, so that the first gear 752 rotates relative to the shaft sleeve 753. This is not limited in this application.

A person skilled in the art may understand that the elastic member 751 is intended to provide a squeezing force for the first gear 752 and the shaft sleeve 753, and a specific location of the elastic member 751 is not limited, provided that the first gear 752 and the shaft sleeve 753 can be mutually squeezed. In an implementation, the elastic member 751 of each damping module 75 is disposed on a side that is of the shaft sleeve 753 and that is away from the damping swing arm 74. In each damping module 75, one end that is of the elastic member 751 and that is away from the damping swing arm 74 is fixed relative to the base 1, and the other end of the elastic member 751 is configured to squeeze the shaft sleeve 753 and the first gear 752.

In another alternative implementation, the damping module 75 may alternatively use another structure. For example, a cam-concave wheel assembly may be disposed in the damping module 75, a concave wheel and a cam in the cam-concave wheel assembly rotate relative to each other, and the cam-concave wheel assembly is squeezed through the elastic member 751, so that the concave wheel and the cam rub relative to each other to generate a damping force.

As shown in FIG. 22 to FIG. 24, in an implementation, first gears 752 of the first damping structure 71 and the second damping structure 72 are disposed in one-to-one correspondence in the second direction Y. A synchronization mechanism 76 is disposed between each pair of first gears 752 corresponding to each other, and the synchronization mechanism 76 includes a second gear 761 and a third gear 762 that are meshed with each other. The second gear 761 is meshed with one first gear 752, and the third gear 762 is meshed with the other first gear 752. When the damping swing arm 74 of any one of the damping structures rotates under driving of a corresponding hinge assembly, the damping swing arm 74 drives, through the synchronization mechanism 76, the damping swing arm 74 of the other damping structure to rotate, so that the first hinge assembly 21 and the second hinge assembly 22 rotate synchronously. Through this structure, when a user rotates a structure on one side of the foldable electronic device 300, a structure on the other side also rotates synchronously under an action of the synchronization mechanism 76, which is more convenient in use and improves customer experience. In another alternative implementation, the synchronization mechanism 76 may alternatively be set in another form. This is not limited in this application.

As shown in FIG. 8a, FIG. 8b, and FIG. 22, in an implementation, the hinge apparatus 100 further includes a first fastened base 281 and a second fastened base 282. Both the first fastened base 281 and the second fastened base 282 are disposed on the base 1 and are fixed relative to the base 1. A quantity of first fastened bases 281 and a quantity of second fastened bases 282 are not limited. In an implementation, one first fastened base 281 is disposed between a group of adjacent hinge assemblies (including one first hinge assembly 21 and one second hinge assembly 22 that are correspondingly disposed in the first direction X) and a group of damping structures (including one first damping structure 71 and one second damping structure 72 that are correspondingly disposed in the first direction X), and one second fastened base 282 is disposed between two rotation arms 742 of each damping swing arm 74 in each group of damping structures. The first fastened base 281 and the second fastened base 282 support adjacent components in the hinge apparatus 100, to improve overall structural strength of the hinge apparatus 100. Both the first fastened base 281 and the second fastened base 282 may be integrally formed with the base 1, or may be disposed as a split structure with the base 1. This is not limited in this application.

In an implementation, the first fastened base 281 may be configured to mount and support the main shaft 23 of each hinge assembly and the damping shaft 73 of each damping structure. For example, in FIG. 8b, the second shaft body 232 of the main shaft 23 of each hinge assembly is mounted on the first fastened base 281 and is rotatably connected to the first fastened base 281, and the damping shaft 73 of each damping mechanism is also mounted on the first fastened base 281 and is rotatably connected to the first fastened base 281. In addition, a fastened end (namely, an end that is in the second direction Y and that is away from the damping swing arm 74) of the elastic member 751 in each damping structure abuts against the first fastened base 281. In an implementation, the second fastened base 282 is configured to mount the damping shaft 73 (for example, each damping shaft 74 in FIG. 24 is mounted on the second fastened base 282 and is rotatably connected to the second fastened base 282). In addition, the second fastened base 282 is disposed between two rotation arms 742 of each damping swing arm 74, to enhance strength of the damping swing arm 74 and reduce a risk of breakage of the rotation arm 742 of the damping swing arm 74.

It is clear that a person skilled in the art may make various modifications and variations to this application without departing from the scope of this application. In this way, if these modifications and variations to this application fall within the scope of the claims of this application and their equivalent technologies, this application is intended to cover these modifications and variations.

## Claims

1. A hinge apparatus, comprising a base, a first hinge assembly, and a second hinge assembly, wherein the first hinge assembly and the second hinge assembly are respectively disposed on two sides of the base in a first direction and are rotatably connected to the base, and each of the first hinge assembly and the second hinge assembly comprises:
a main swing arm, wherein a main shaft is disposed on the base, and the main swing arm is rotatably connected to the base through the main shaft, so that the main swing arm rotates around a first axis relative to the base; and the first axis extends in a second direction, the second direction is an extension direction of the main shaft, and the second direction is perpendicular to the first direction;
a movable plate, wherein the movable plate is rotatably connected to the base through the main swing arm, a rotation axis is the first axis, and the movable plate is slidably connected to the main swing arm; and
a compensation mechanism, wherein the compensation mechanism comprises a first connecting rod, a second connecting rod, and a third connecting rod, each of the first connecting rod, the second connecting rod, and the third connecting rod comprises a concentric portion and a rotating portion that are spaced apart, concentric portions of all the connecting rods are rotatably connected to each other, and a rotation axis between any two connecting rods is a second axis;
the first connecting rod is rotatably connected to the base through the rotating portion of the first connecting rod, so that the concentric portions of all the connecting rods rotate around a third axis relative to the base; the second connecting rod is rotatably connected to the base through the rotating portion of the second connecting rod, and the rotating portion of the second connecting rod is mounted on the main shaft or the main swing arm, so that the rotating portion of the second connecting rod rotates around the first axis relative to the base under driving of the main swing arm and drives the concentric portions of all the connecting rods to rotate around the third axis relative to the base; the third connecting rod is rotatably connected to the movable plate through the rotating portion of the third connecting rod, and a rotation axis between the movable plate and the third connecting rod is a fourth axis; and all the second axis, the third axis, and the fourth axis extend in the second direction; and
when the main swing arm rotates relative to the base, the movable plate slides relative to the main swing arm under driving of the main swing arm and the compensation mechanism, to generate displacement in a direction toward or away from the base.

2. The hinge apparatus according to claim 1, wherein each hinge assembly further comprises an eccentric shaft, and the rotating portion of the second connecting rod is mounted on the main shaft through the eccentric shaft and is rotatably connected to the main shaft; and
the eccentric shaft penetrates the main shaft, the rotating portion of the second connecting rod is disposed as a sleeve structure and is sleeved on an outer circumference of the eccentric shaft, and when the rotating portion of the second connecting rod rotates around the first axis relative to the base under driving of the main swing arm, the second connecting rod rotates around a fifth axis relative to the main shaft, wherein the fifth axis is an axis of the eccentric shaft and is parallel to the first axis.

3. The hinge apparatus according to claim 2, wherein a shaft hole is provided on the main shaft, the shaft hole and an axis of the main shaft are spaced apart in a radial direction of the main shaft, and the eccentric shaft passes through the shaft hole; and
the shaft hole is provided on an outer wall surface of the main shaft, a notch is formed on the outer wall surface of the main shaft, and a partial structure of the eccentric shaft is embedded in the main shaft in the radial direction of the main shaft.

4. The hinge apparatus according to any one of claims 1 to 3, wherein in each hinge assembly, the third axis is located, in the first direction, on a side that is of the first axis and that is close to another hinge assembly.

5. The hinge apparatus according to any one of claims 1 to 4, wherein in each hinge assembly, the concentric portion of the first connecting rod comprises a first connecting portion, the concentric portion of the second connecting rod comprises two second connecting portions spaced apart in the second direction, and the concentric portion of the third connecting rod comprises two third connecting portions spaced apart in the second direction;
in the second direction, the two third connecting portions of the third connecting rod are disposed between the two second connecting portions of the second connecting rod, and the first connecting portion of the first connecting rod is disposed between the two third connecting portions of the third connecting rod; and
the compensation mechanism further comprises a concentric shaft, each of the first connecting portion, the two second connecting portions, and the two third connecting portions is disposed as a sleeve structure, all the connecting portions are coaxially disposed in the second direction, and the concentric shaft penetrates all the connecting portions, so that any two connecting rods rotate relative to each other around the second axis.

6. The hinge apparatus according to claim 5, wherein the rotating portion of the first connecting rod is connected to the first connecting portion through a first connecting plate, the rotating portion of the second connecting rod is connected to the two second connecting portions through a second connecting plate, and the rotating portion of the third connecting rod is connected to the two third connecting portions through a third connecting plate; and
the first connecting plate, the second connecting plate, and the third connecting plate each are disposed as a plate structure.

7. The hinge apparatus according to claim 6, wherein the rotating portion of the first connecting rod, the first connecting portion, and the first connecting plate are disposed as an integrated structure; the rotating portion of the second connecting rod, the two second connecting portions, and the second connecting plate are disposed as an integrated structure; and the rotating portion of the third connecting rod, the two third connecting portions, and the third connecting plate are disposed as an integrated structure.

8. The hinge apparatus according to any one of claims 1 to 7, wherein the main swing arm comprises a main body portion and two connecting arms connected to the main body portion, the two connecting arms are fastened to the main shaft, and the main shaft rotates around the first axis relative to the base under driving of the main swing arm, so that the main swing arm rotates around the first axis relative to the base;
the movable plate comprises a body portion and a rotatable connecting member connected to the body portion, and the rotatable connecting member is rotatably connected to the rotating portion of the third connecting rod, so that the third connecting rod is rotatably connected to the movable plate; and
the main body portion of the main swing arm and the body portion of the movable plate are stacked and are slidably connected through at least one sliding structure; and each sliding structure in the at least one sliding structure comprises a slide rail and a sliding block that are slidably connected to each other, one of the slide rail and the sliding block is disposed on the body portion of the movable plate, and the other of the slide rail and the sliding block is disposed on the main body portion of the main swing arm.

9. The hinge apparatus according to claim 8, wherein the main shaft comprises a first shaft body and a second shaft body that are spaced apart in the second direction, each of the two connecting arms of the main swing arm is disposed as a sleeve structure, one of the two connecting arms is sleeved and fastened on the first shaft body, the other of the two connecting arms is sleeved and fastened on the second shaft body, and when each hinge assembly rotates relative to the base, the first shaft body and the second shaft body of the main shaft rotate synchronously; and
a first hollow portion is disposed on the main body portion of the main swing arm, the first hollow portion is located between the two connecting arms in the second direction and is in communication with space between the two connecting arms, so that the two connecting arms and the main body portion enclose accommodating space, and the entire compensation mechanism is located in the accommodating space.

10. The hinge apparatus according to claim 8 or 9, wherein the rotatable connecting member of the movable plate comprises two rotating arms spaced apart in the second direction, and the rotating portion of the third connecting rod is disposed between the two rotating arms; and
all the rotating portion of the third connecting rod and the two connecting arms of the movable plate are disposed as sleeve structures and are coaxially disposed in the second direction, the compensation mechanism further comprises a rotatable connecting shaft, and the rotatable connecting shaft penetrates the rotating portion of the third connecting rod and the two connecting arms of the movable plate, so that the third connecting rod is rotatably connected to the movable plate.

11. The hinge apparatus according to any one of claims 8 to 10, wherein the main body portion of the main swing arm is slidably connected to the body portion of the movable plate through two sliding structures;
a first bump, a second bump, and a third bump that are sequentially spaced apart in the second direction are disposed on the body portion of the movable plate, and each of the first bump, the second bump, and the third bump protrudes from the body portion toward a side close to the main swing arm;
the entire main body portion of the main swing arm is located between the first bump and the third bump in the second direction, a groove corresponding to the second bump is provided on the main body portion, and the second bump is embedded in the groove and slides in the groove; and
in the second direction, one slide rail is formed between the first bump and the second bump, one slide rail is formed between the second bump and the third bump, parts that are of the main body portion of the main swing arm and that are located on two sides of the groove each form one sliding block, and each sliding block is in one-to-one correspondence with each slide rail.

12. The hinge apparatus according to any one of claims 8 to 11, wherein each hinge assembly further comprises a support plate, and the support plate is configured to support a display screen of a foldable electronic device and is stacked on a side that is of the movable plate and that faces away from the main swing arm; and
the support plate is separately slidably connected to the movable plate and the main swing arm, when the main swing arm rotates around the first axis relative to the base, the support plate slides relative to the main swing arm under driving of the movable plate and slides relative to the movable plate along an arc-shaped track, so that the support plate rotates around a sixth axis relative to the movable plate, wherein the sixth axis extends in the second direction.

13. The hinge apparatus according to claim 12, wherein the support plate comprises a plate body, a first boss, and two second bosses respectively located on two sides of the first boss in the second direction, and each of the first boss and the two second bosses is connected to the plate body and protrudes from the plate body toward a side close to the main swing arm;
the main swing arm comprises a connecting boss protruding from the main body portion toward a side close to the support plate, a second hollow portion is disposed on the body portion of the movable plate, and both the connecting boss of the main swing arm and the first boss of the support plate are accommodated in the second hollow portion of the movable plate and are slidably connected to each other, so that the support plate is slidably connected to the movable plate; and
the entire movable plate is located between the two second bosses of the support plate in the second direction, arc-shaped slide rails are disposed at two ends of the movable plate, and each of the two second bosses is disposed as an arc-shaped structure and slides in a corresponding arc-shaped slide rail, so that the support plate slides relative to the movable plate along the arc-shaped track.

14. The hinge apparatus according to claim 13, wherein an arc-shaped hole is provided on the first boss of the support plate, the arc-shaped hole extends through the first boss in the second direction and extends along an arc line in a plane perpendicular to the second direction, the connecting boss of the main swing arm comprises two connecting brackets spaced apart in the second direction, and the first boss is located between the two connecting brackets; and
the connecting boss of the main swing arm further comprises a sliding rod, two ends of the sliding rod are mounted on the two connecting brackets, the sliding rod passes through the arc-shaped hole of the first boss, and the sliding rod slides in the arc-shaped hole, so that the support plate slides relative to the main swing arm along an arc-shaped track.

15. The hinge apparatus according to any one of claims 1 to 14, wherein the hinge apparatus further comprises a fastened bracket disposed on the base, and the rotating portion of the first connecting rod in each hinge assembly is rotatably connected to the fastened bracket, so that the first connecting rod in each hinge assembly is rotatably connected to the base, and the third axes of all the hinge assemblies coincide.

16. The hinge apparatus according to claim 15, wherein the fastened bracket comprises a first bracket and a second bracket that are spaced apart in the second direction, the rotating portion of the first connecting rod in each hinge assembly is disposed between the first bracket and the second bracket, the rotating portion of the first connecting rod in the first hinge assembly is rotatably connected to the first bracket, and the rotating portion of the second connecting rod in the second hinge assembly is rotatably connected to the second bracket; and
the hinge apparatus further comprises a fastened shaft, all the first bracket, the second bracket, and the rotating portion of the first connecting rod in each hinge assembly are disposed as sleeve structures and are coaxially disposed in the second direction, and the fastened shaft sequentially penetrates the first bracket, the rotating portion of the first connecting rod in the first hinge assembly, the rotating portion of the first connecting rod in the second hinge assembly, and the second bracket, so that the first connecting rod in each hinge assembly is rotatably connected to the base.

17. The hinge apparatus according to any one of claims 1 to 16, wherein the base comprises a bottom plate, a first side wall and a second side wall that are disposed opposite to each other in the first direction, and a third side wall and a fourth side wall that are disposed opposite to each other in the second direction, the bottom plate, the first side wall, the second side wall, the third side wall, and the fourth side wall enclose an accommodating groove, the main shaft in each hinge assembly is disposed in the accommodating groove, and a part of the compensation mechanism is located in the accommodating groove; and
the base further comprises a cover plate, the cover plate is disposed opposite to the bottom plate in a third direction and is configured to support the display screen of the foldable electronic device, wherein the third direction is perpendicular to the first direction and is perpendicular to the second direction.

18. The hinge apparatus according to claim 17, wherein the hinge apparatus further comprises a first damping structure and a second damping structure, and the first damping structure and the second damping structure are respectively disposed on two sides of the base in the first direction;
each of the first damping structure and the second damping structure comprises a damping shaft and a damping swing arm, the damping shaft is rotatably connected to the base, and the damping swing arm is fastened to the damping shaft, so that the damping swing arm is rotatably connected to the base through the damping shaft, and the damping swing arm of the first damping structure is fastened to the main swing arm of the first hinge assembly, so that the damping swing arm of the first damping structure rotates around the first axis of the first hinge assembly relative to the base under driving of the main swing arm; and the damping swing arm of the second damping structure is fastened to the main swing arm of the second hinge assembly, so that the damping swing arm of the second damping structure rotates around the first axis of the second hinge assembly relative to the base under driving of the main swing arm;
each damping structure further comprises at least one damping module, each damping module in the at least one damping module comprises an elastic member, a first gear, and a shaft sleeve that separately penetrate the damping shaft, the shaft sleeve is disposed between the elastic member and the first gear in the second direction, the shaft sleeve is sleeved on the damping shaft, and the first gear is disposed on the damping shaft and is fixed relative to the damping shaft, so that the first gear rotates relative to the base and rotates relative to the shaft sleeve under driving of the damping shaft; and
the first gear comprises a first end surface facing the shaft sleeve, the shaft sleeve comprises a second end surface facing the first gear, and the elastic member applies an elastic force to the shaft sleeve and the first gear through deformation of the elastic member, so that the first end surface and the second end surface are mutually squeezed.

19. The hinge apparatus according to claim 18, wherein each damping structure comprises two damping modules, the two damping modules are respectively disposed on two sides of the damping swing arm in the second direction, and the elastic member of each damping module is disposed on a side that is of the shaft sleeve and that is away from the damping swing arm; and
in each damping module, one end that is of the elastic member and that is away from the damping swing arm is fixed relative to the base, and the other end of the elastic member is configured to squeeze the shaft sleeve and the first gear.

20. The hinge apparatus according to claim 18 or 19, wherein first gears of the first damping structure and the second damping structure are disposed in one-to-one correspondence in the second direction, a synchronization mechanism is disposed between each pair of first gears corresponding to each other, the synchronization mechanism comprises a second gear and a third gear that are meshed with each other, the second gear is meshed with one first gear, the third gear is meshed with the other first gear, and when the damping swing arm of any one of the damping structures rotates under driving of a corresponding hinge assembly, the damping swing arm drives, through the synchronization mechanism, the damping swing arm of the other damping structure to rotate, so that the first hinge assembly and the second hinge assembly rotate synchronously.

21. A foldable apparatus, comprising a first housing, a second housing, and the hinge apparatus according to any one of claims 1 to 20, wherein the first housing and the second housing are respectively disposed on two sides of the hinge apparatus in the first direction, the movable plate of the first hinge assembly is fastened to the first housing, the movable plate of the second hinge assembly is fastened to the second housing, and the first housing and the second housing generate displacement in a direction toward or away from the base when rotating relative to each other.

22. A foldable electronic device, comprising a display screen, and further comprising the foldable apparatus according to claim 21, wherein the display screen is laid on the foldable apparatus, and when the foldable electronic device is in a folded state, the foldable apparatus surrounds an outer side of the display screen.
